# EUROPÄISCHE PATENTSCHRIFT

(11) **EP 3 103 135 B1**
(45) Veröffentlichungstag und Bekanntmachung des Hinweises auf die Patenterteilung: **12.05.2021**
(21) Anmeldenummer: 14702826.0
(22) Anmeldetag: 03.02.2014
(51) Int. Cl.: H01L 21/67, H01L 21/687

(54) **VERFAHREN UND VORRICHTUNG ZUM BONDEN VON SUBSTRATEN**
METHOD AND DEVICE FOR BONDING SUBSTRATES
PROCÉDÉ ET DISPOSITIF DE LIAISON DE SUBSTRATS

(43) Veröffentlichungstag der Anmeldung: 14.12.2016
(60) Teilanmeldung: 17200753.6
(73) Patentinhaber: Ev Group E. Thallner GmbH, 4782 St. Florian am Inn (AT)
(72) Erfinder: LINDNER, Friedrich Paul, A-4780 Schärding (AT)
(74) Vertreter: Schneider, Sascha
(86) Internationale Anmeldenummer: PCT/EP2014/052037
(87) Internationale Veröffentlichungsnummer: WO 2015/113641

(56) Entgegenhaltungen:
- EP-A1- 1 341 216
- JP-A- 2009 141 043
- US-A1- 2012 304 921
- US-A1- 2012 318 856

## Beschreibung

Die vorliegende Erfindung betrifft ein Verfahren zum Bonden einer ersten Kontaktfläche eines ersten Substrats mit einer zweiten Kontaktfläche eines zweiten Substrats gemäß Patentanspruch 1 sowie eine korrespondierende Vorrichtung gemäß Patentanspruch 9.

Bekannt sind Ausrichtungseinrichtungen, bei welchen die Ausrichtung (engl.: Alignment) der Substrate zueinander unter normaler Atmosphäre stattfindet.

Die zueinander ausgerichteten Substrate werden noch in der Ausrichtungseinrichtung temporär miteinander fixiert und anschließend zu einer Hochvakuumbondeinrichtung transferiert und dort unter Vakuum permanent gebondet, wobei die zum Bonden notwendige Temperatur durch Wärmequellen erzeugt wird.

Die Druckschrift US 2012/0318856 offenbart eine Vorrichtung zum permanenten Bonden eines Substratstapels, wobei der Substratstapel auf eine Heizplatte abgelegt wird.

Die Wärmequellen nebst dazugehörigen Druckplatten befinden sich oberhalb bzw. unterhalb der zu bondenden Substrate. Die obere Wärmequelle und die obere Druckplatte sind bewegbar ausgeführt. Die untere Wärmequelle und der Probenhalter am Boden der Hochvakuumbondeinrichtung sind statisch ausgeführt.

In der Ausrichtungseinrichtung werden die beiden zueinander auszurichtenden Substrate auf einem Probenhalter (engl.: bond chuck) fixiert.

Die Fixierung erfolgt dabei meistens mit mechanischen Klemmen. Die auf dem Probenhalter aufgenommenen und zueinander ausgerichteten Substrate werden anschließend zur Hochvakuumbondeinrichtung transportiert. Der Probenhalter wird auf der unteren Wärmequelle abgelegt.

Auf Grund der immer kleiner werdenden Strukturen wirken sich durch die thermische Einwirkung auftretende Verformungen der Substrate negativ auf das Bondergebnis aus.

Aufgabe der vorliegenden Erfindung ist es daher, ein Verfahren anzugeben, mit dem das Bondergebnis verbessert wird.

Diese Aufgabe wird mit den Merkmalen der Patentansprüche 1 und 9 gelöst. Vorteilhafte Weiterbildungen der Erfindung sind in den Unteransprüchen angegeben.

Die Grundidee der vorliegenden Erfindung ist es, die Substrate des an Kontaktflächen der Substrate ausgerichteten Substratstapels zum, insbesondere permanenten, Bonden in der Bondeinrichtung schonend und gleichmäßig von beiden zu heizenden Oberflächen (die von den Kontaktflächen abgewandten Seiten) der Substrate aus aufzuheizen, um, insbesondere unterschiedliche, Verformungen der beiden Substrate zu minimieren oder ganz zu vermeiden.

Die Erfindung beschreibt insbesondere eine modularisierte Vorrichtung sowie eine Prozesskette, welche es ermöglicht, eine Ausrichtungseinrichtung zur Ausrichtung und zum temporären Verbinden von zwei oder mehr Substraten zu einem Substratstapel zu realisieren. Dabei werden die hierin ausgerichteten Substrate unter Berücksichtigung eines besonders sensitiven Umgangs über eine Hochvakuumtransferstrecke (also ohne Unterbrechung des Vakuums) zu einer Bondeinrichtung überführt. In dieser werden die Substrate dauerhaft und untrennbar (also permanent) zusammengefügt (gebondet), ohne die Substrate übermäßigen oder unterschiedlichen Dehnungen und Verzerrungen auszusetzen.

Bevorzugt wird die Ausrichtungseinrichtung so ausgeführt, dass zur Fixierung des Substratstapels in der Ausrichtungseinheit vor der Überführung in eine Bondeinheit den Substratstapel nicht kontaminierende Verbindungselemente vorgesehen sind, die den Substratstapel temporär zusammenhalten. Die Verbindungselemente sind nach dem Bonden rückstandslos entfernbar.

Der Substratstapel wird innerhalb einer Vakuumtransferstrecke in einer Ausführungsform der Erfindung zur Verbesserung des Bondergebnisses mit einer oder mehreren Einrichtungen zur Reduktion von Oberflächengasen und/oder Feuchtigkeit bearbeitet.

Die Erfindung handelt von einer Anlage bzw. Vorrichtung und einem Verfahren, mit dem der Substratstapel symmetrisch erwärmt wird. Als Symmetrieebene dienen die kontaktierten Kontaktflächen der Substrate des Substratstapels. Mit anderen Worten wird der Substratstapel von beiden Seiten äquitherm erhitzt.

Die Erfindung handelt demnach von einem Verfahren und einer Vorrichtung zum Heizen und Bonden eines Substratstapels. Das Heizen erfolgt symmetrisch, insbesondere durch Infrarotstrahlung.

Gemäß einem weiteren Aspekt der vorliegenden Erfindung sind die erfindungsgemäßen Bauteile Bestandteil einer, insbesondere modularisiert aufgebauten, Anlage, insbesondere eines Hochvakuumclusters. Im Hochvakuumcluster ist eine Prozesskette bis zum Bonden eines Substratstapels durchführbar. Im Hochvakuumcluster wird besonderes Augenmerk auf den sensitiven Umgang mit den zu bondenden Substraten gelegt. Der sensitive Umgang betrifft insbesondere eine gleichmäßige, insbesondere symmetrische, Wärmeeinbringung in die zu behandelnden Substrate durch unterschiedliche Heizzonen welche bevorzugt durch eine obere dynamisch verschiebbare Heizeinrichtung und dazugehörigem Probenhalter (engl.: chucks) und eine untere, insbesondere starre bzw. statische, Heizeinrichtung erreicht wird.

Bevorzugt wird durch kontrolliertes Heranführen der oberen Heizeinrichtung gegen die untere Heizeinrichtung ein besonders schonender Bondprozess ermöglicht.

Die erfindungsgemäßen Prozessschritte werden bevorzugt unter Beibehaltung/Aufrechterhaltung des in der Ausrichtungseinheit erzeugten Vakuums, insbesondere auch bei dem Transport durch die Vakuumtransferstrecke mit einer Vakuumtransferkammer, insbesondere einer Hochvakuumtransferkammer, abgearbeitet.

In einer besonderen Ausführungsform der Vorrichtung, insbesondere Hochvakuumbondvorrichtung, ist es denkbar, neben einer symmetrischen Wärmeeinbringung, vorzugsweise durch gleichmäßiges Heranführen der gegenüberliegenden Heizflächen der Heizeinrichtungen hin zu den zu prozessierenden Substraten, die Substrate in Abhängigkeit deren Materialart sowie deren Dicke und/oder unter Berücksichtigung des Dehnungskoeffizienten die Wärmeeinbringung so zu steuern, um unterschiedliche Verformungen, insbesondere Dehnungen und/oder Verzerrungen, insbesondere auch bei der Verwendung von verschiedenartigen Materialien, zu vermeiden. Insbesondere dient die symmetrische Erwärmung der gleichmäßigen (also homogenen) Durchwärmung von beiden Seiten des Substratstapels.

Wichtige Prozessparameter sind insbesondere die Heizrate und/oder die Heizleistung. Die Heizrate definiert, um wieviel Grad sich das Substrat pro Zeiteinheit erwärmt. Insbesondere wird die Heizrate auf einen Wert zwischen 1 °C/min und 1000 °C/min eingestellt. Kleinere Heizraten wären zwar möglich, sind aber bei den angestrebten Temperaturen nicht mehr wirtschaftlich, da der Aufheizvorgang zu lange benötigen würde. Heizraten, die größer sind als 1000 °C/min, würden die Substrate so schnell erwärmen, dass es zu Schädigungen der Substrate und/oder zu Ausrichtungsfehlern zwischen den Substraten kommen kann. Die Heizleistung gibt die Wärmemenge pro Zeiteinheit an, die benötigt wird, um ein Objekt auf eine vorgegebene Temperatur zu heizen. Die Heizleistung wird durch, insbesondere in den Probenhaltern angeordnete, Heizelemente aufgebracht, die vorwiegend elektrisch betrieben werden. Unter der Annahme idealer Bedingungen, daher keinerlei Verlustleistungen und einer 100% Umsetzung der eingebrachten elektrischen Energie in Wärmeenergie, kann eine Untergrenze der notwendigen (elektrischen) Leistung berechnet werden, die mindestens notwendig ist, um ein Substrat mit gewissem Durchmesser und gewisser Dicke, innerhalb einer gewünschten Zeit auf die gewünschte Temperatur zu bringen. Die Heizleistung entspricht der in ein Substrat eingebrachten Energie pro Zeiteinheit. Die eingebrachte Energie entspricht insbesondere der eingebrachten Wärme. Die Wärme, die notwendig ist, um einen Körper von einer Ausgangstemperatur auf eine Endtemperatur zu erwärmen, entspricht dem Produkt aus der zu überwindenden Temperaturdifferenz, spezifischer Wärmekapazität und Masse des Körpers. Die Masse des Körpers kann bei gegebener Dichte und den Abmessungen berechnet werden. Substrate sind vorzugsweise rund, und sehr oft Einkristalle. Daher besitzen sie zu berechnende Geometrien und eine homogene Dichte. Die Berechnung der Masse als Funktion der geometrischen Parameter, insbesondere der Dicke und des Durchmessers kann erfindungsgemäß automatisiert erfolgen. Die so ermittelte Wärmemenge wird dann durch die gewünschte minimale Zeit, in der die entsprechende Temperaturdifferenz überwunden werden soll, dividiert. Daraus ergibt sich die Heizleistung. Die elektrische Leistung wird dann entsprechend gewählt. Da nicht die gesamte elektrische Leistung in Wärmeleistung umgewandelt wird, wird die tatsächlich einzubringende elektrische Leistung entsprechend höher gewählt, um die Verlustleistung zu kompensieren.

| **Materialparameter** | | | | | | | **Prozessparameter** | | | |
|---|---|---|---|---|---|---|---|---|---|---|
| **Cₛ** | **Dichte** | **Dichte** | **t** | **d** | **V** | **Masse** | **ΔT** | **Q** | **t** | **L** |
| **J kg⁻¹ K^{- 1}** | **g cm⁻³** | **kg m⁻³** | **m** | **m** | **m³** | **kg** | **K** | **J** | **min** | **Watt** |
| 710 | 2,336 | 2336,000 | 0,000725 | 0,200 | 2,27765E-05 | 0,053 | 475,000 | 17943,72795 | 1 | 299,062 |
| 710 | 2,336 | 2336,000 | 0,000725 | 0,200 | 2,27765E-05 | 0,053 | 475,000 | 17943,72795 | 5 | 59,812 |
| 710 | 2,336 | 2336,000 | 0,000725 | 0,200 | 2,27765E-05 | 0,053 | 475,000 | 17943,72795 | 10 | 29,906 |
| 710 | 2,336 | 2336,000 | 0,000725 | 0,200 | 2,27765E-05 | 0,053 | 475,000 | 17943,72795 | 15 | 19,937 |
| 710 | 2,336 | 2336,000 | 0,000725 | 0,200 | 2,27765E-05 | 0,053 | 475,000 | 17943,72795 | 20 | 14,953 |
| 710 | 2,336 | 2336,000 | 0,000725 | 0,200 | 2,27765E-05 | 0,053 | 475,000 | 17943,72795 | 25 | 11,962 |
| 710 | 2,336 | 2336,000 | 0,000725 | 0,200 | 2,27765E-05 | 0,053 | 475,000 | 17943,72795 | 30 | 9,969 |
| 710 | 2,336 | 2336,000 | 0,000725 | 0,200 | 2,27765E-05 | 0,053 | 475,000 | 17943,72795 | 35 | 8,545 |
| 710 | 2,336 | 2336,000 | 0,000725 | 0,200 | 2,27765E-05 | 0,053 | 475,000 | 17943,72795 | 40 | 7,477 |
| 710 | 2,336 | 2336,000 | 0,000725 | 0,200 | 2,27765E-05 | 0,053 | 475,000 | 17943,72795 | 45 | 6,646 |
| 710 | 2,336 | 2336,000 | 0,000725 | 0,200 | 2,27765E-05 | 0,053 | 475,000 | 17943,72795 | 50 | 5,981 |
| 710 | 2,336 | 2336,000 | 0,000725 | 0,200 | 2,27765E-05 | 0,053 | 475,000 | 17943,72795 | 55 | 5,437 |
| 710 | 2,336 | 2336,000 | 0,000725 | 0,200 | 2,27765E-05 | 0,053 | 475,000 | 17943,72795 | 60 | 4,984 |

Die Tabelle zeigt die minimale elektrische Leistung, die notwendig ist, um ein Siliziumsubstrat mit einem Durchmesser von 200 mm und einer Dicke von 725 µm in den angegebenen Zeiten von 25 °C auf 525 °C zu erwärmen. Die tatsächliche elektrische Leistung wird auf Grund von Verlustleistungen größer sein. Die elektrische Leistung der verwendeten Heizer wird insbesondere größer als 100 W, vorzugsweise größer als 1000 Watt, noch bevorzugter größer als 5000 Watt, am bevorzugtesten größer als 10000 Watt, am allerbevorzugtesten größer als 20000 Watt, gewählt.

Erfindungsgemäß erfolgt die Druckbeaufschlagung des ersten Substrats insbesondere durch eine erste Druckfläche einer ersten Druckplatte, die vorzugsweise gleichzeitig die erste Heizfläche ist. Die Druckbeaufschlagung des zweiten Substrats erfolgt insbesondere durch eine zweite Druckfläche einer zweiten Druckplatte, die vorzugsweise gleichzeitig die zweite Heizfläche ist.

Erfindungsgemäß werden hierzu insbesondere vorher zu bestimmende und festgelegte Rezepte bzw. Verfahrensabläufe angewendet, die vorzugsweise materialspezifische Eigenschaften und/oder die konkrete Beschaffenheit, insbesondere die Materialstärke, der zu bondenden Substrate berücksichtigen. Neben einer möglichen vollautomatischen Abarbeitung der Rezepte ist auch eine semiautomatische Nutzung der Einrichtung sowie darüber hinaus auch eine manuelle Nutzung der in Rede stehenden Einrichtung denkbar.

Soweit die zu bondenden Substrate aus Materialien bestehen, welche die thermische Strahlung sehr stark reflektieren und damit eine gewünschte Wärmeeinbringung somit erheblich verlangsamen bzw. erschweren, werden die Rezepte entsprechend angepasst. Umgekehrt wäre aber auch eine erhöhte Absorption der thermischen Strahlung durch entsprechend stark absorbierende Materialien und/oder Oberflächenbeschaffenheit denkbar, wobei die Rezepte, insbesondere Aufheizzeiten, entsprechend verkürzt würden.

Die erfindungsgemäße Einrichtung ist insbesondere in der Lage, das Aufheizen beeinflussende Faktoren, insbesondere durch Sensoren, zu erkennen und bei dem Verfahrensablauf zu berücksichtigen und/oder bei folgenden Schritten oder folgenden Substratstapeln auszusteuern.

Die erfindungsgemäße Einrichtung ermöglicht es außerdem in bevorzugter Weise, die Substrate durch Konvektion und/oder verschiedene Heizzonen vorteilhaft zu behandeln, so dass eine gleichmäßige Wärmeeinbringung erzielt wird. Die Erwärmung der Substrate erfolgt vorzugsweise über Konvektion eines in die Bondeinrichtung, insbesondere in den Probenhalter, noch bevorzugter einen Noppenprobenhalter (engl.: Noppenchuck), eingebrachten Gases (insbesondere als eigenständiger Erfindungsaspekt offenbart). Während das Gas für die Wärmeübertragung durch Konvektion sorgt, wird die Bondeinrichtung, vorzugsweise kontinuierlich, evakuiert, sodass sich in der Bondkammer ein Druck von weniger als 10⁻² mbar, noch bevorzugter weniger als 10⁻³ mbar einstellt. Die Einbringung des Gases erfolgt insbesondere vor und/oder während einer Evakuierung der Bondeinrichtung. Das Gas kann von außen, bevorzugt durch eine Leitung des Probenhalters und/oder einer Druckplatte zum Substratstapel und/oder Probenhalter bzw. Druckplatte geleitet werden. Bei einer erfindungsgemäßen Verwendung eines Probenhalters mit genoppter Kontaktfläche, insbesondere Heizfläche der Heizeinrichtung, verteilt sich das Gas auf Grund der definierten Topographie optimal zwischen dem Substrathalter und/oder der Druckplatte und dem Substratstapel.

Während die zueinander ausgerichteten Substratstapel im Bonder (insbesondere auf einem Noppenchuck) liegen und die Umgebung um die Substrate evakuiert wird, strömt (insbesondere aus dem Noppenchuck) ein Gas, welches die Wärmeleitung zwischen dem (Noppen)probenhalter und dem Substratstapel sicherstellt. Außen herum wird evakuiert und zwischen Substratstapel und (Noppen)probenhalter wird gespült. Durch das Spülen wird der durch die Vakuumeinrichtung angelegte Druck in der Bondkammer entsprechend reduziert.

Einer der wichtigsten erfindungsgemäßen Aspekte besteht darin, zu verhindern, dass durch das Aufheizen der Substrate eine Verschiebung der Substrate zueinander erfolgt, wodurch die Ausrichtung der Substrate zueinander wieder verloren geht. Physikalisch betrachtet besteht die Erfindung insbesondere darin, dafür zu sorgen, dass die bei einer Temperaturänderung eintretenden thermischen Dehnungen beider Substrate immer gleich sind. Bestehen beide Substrate aus demselben Material, so werden die beiden Substrate vorzugsweise gleich temperiert.

In Weiterbildung der Erfindung werden die die Heizeinrichtungen beim Heizen und das Annähern daher derart gesteuert, dass zumindest während der überwiegenden Dauer des Annäherns die Differenz der mittleren Temperatur des ersten Substrats und der mittleren Temperatur des zweiten Substrats kleiner 5°C, insbesondere kleiner 1°C, bevorzugt kleiner 0,5°C, noch bevorzugter kleiner 0,1°C, beträgt. Sollten die beiden zueinander ausgerichteten Substrate zwar aus demselben Material bestehen, aber unterschiedliche Dicken aufweisen, so kann es passieren, dass die Temperaturänderung in einem der beiden Substrate, insbesondere in dem Substrat mit der größeren Dicke, langsamer verläuft als in dem anderen Substrat, insbesondere dem mit der geringeren Dicke. In einer solchen Situation kann es daher während dem Aufheizvorgang trotz gleicher Materialkennwerte, aber unterschiedlicher Geometriekennwerte zu einer Verschiebung der beiden Substrate kommen. Im Idealfall würde sich aber nach der totalen Erwärmung der Substrate die vorher durch eine Ausrichtungseinheit erzeugte Ausrichtung wieder korrekt einstellen. Sollten die Materialien und damit die Materialkennwerte der beiden Substrate, insbesondere der thermische Ausdehnungskoeffizient bzw. der thermische Ausdehnungstensor und/oder die Wärmeleitfähigkeit und/oder die Wärmekapazität, unterschiedlich sein, kommt es zu einer nicht gewollten Verschiebung der Substrate zueinander. Diese kann durch nicht erfindungsgemäße Verfahren kompensiert werden. In diesem Fall werden die Heizeinrichtungen beim Heizen und das Annähern derart gesteuert, dass zumindest während der überwiegenden Dauer des Annäherns die Differenz der mittleren Temperatur des ersten Substrats und der mittleren Temperatur des zweiten Substrats größer als 0.1°C, insbesondere größer 0.5°C, bevorzugt größer 1°C, noch bevorzugter größer 5°C, beträgt um die Differenz der thermischen Dehnungen der beiden Substrate zu kompensieren, sodass die Ausrichtung möglichst gut erhalten bleibt.

Alternativ oder zusätzlich kann es vorteilhaft sein, die Heizeinrichtungen beim Heizen und das Annähern derart zu steuern, dass die an der ersten Oberfläche auftreffende Strahlungsenergie der ersten Heizfläche während des Annäherns gleich ist wie die an der zweiten Oberfläche auftreffende Strahlungsenergie der zweiten Heizfläche.

Gemäß einer weiteren, vorteilhaften Ausführungsform der Erfindung wird eine Verbesserung des Bondergebnisses durch eine dem Bonden vorgeschaltete Erwärmung der Substrate und damit einhergehend einem Ausgasen, insbesondere innerhalb der Vakuumtransferstrecke und noch vor Erreichen der eigentlichen Bondeinrichtung, erreicht.

Nach dem Erreichen der Bondeinrichtung und noch vor dem eigentlichen Bondvorgang wird bevorzugt eine auf die individuellen Anforderungen abgestimmte, gleichmäßige bzw. homogene (symmetrische oder asymmetrische) Erwärmung der Substrate vorgenommen. Hierdurch werden (thermische) Spannungen durch ungleichmäßige Dehnungen innerhalb der Substrate weitgehend vermieden, was das gewünschte Bondergebnis positiv beeinflusst. Der thermische Ausdehnungskoeffizient von Silizium liegt beispielsweise im Bereich von 2.6 10⁻⁶ K⁻¹. Sind beide Substrate aus dem Material Silizium gefertigt, besitzen auch beide denselben (gemittelten) thermischen Ausdehnungskoeffizienten (unter der Annahme, dass beide Substrate dieselbe Kristallorientierung besitzen wovon meistens ausgegangen werden kann, da die meisten Siliziumwafer eine kristallographische (100) Orientierung besitzen und unter der Annahme, dass die thermische Ausdehnung in der Substratebene isotrop ist). Dementsprechend werden thermisch gleich belastete Substrate auch gleiche thermische Dehnungen erfahren. Sollten sich die Materialien unterschieden sind deren thermische Ausdehnungskoeffizienten im Allgemeinen unterschiedlich. Diese unterschiedlichen thermischen Dehnungen können erfindungsgemäß kompensiert werden.

Gemäß einem weiteren Aspekt der vorliegenden Erfindung ist eine Aufnahmeeinrichtung zur Aufnahme des Substratstapels zumindest während des Bondens vorgesehen. Die Aufnahmeeinrichtung ist insbesondere geeignet, den Substratstapel, insbesondere am Umfang oder in einem Umfangsbereich, aufzunehmen. Weiter bevorzugt ist die Aufnahmeeinrichtung geeignet, die Substrate an den Kontaktflächen zusammenzuhalten und in der ausgerichteten Position zu halten, bis die Substrate gebondet sind. Die Aufnahmeeinrichtung, insbesondere der Noppenprobenhalter, beaufschlagt bzw. kontaktiert vorzugsweise nur einen kleinen Abschnitt der von den Kontaktflächen abgewandten Oberflächen der Substrate bevorzugt bedeckt die Aufnahmeeinrichtung die mit Strahlungswärme zu beaufschlagende Oberfläche der Substrate kaum oder gar nicht. Anders ausgedrückt liegt der überwiegende Teil, insbesondere mindestens ¾, bevorzugt mindestens 90%, der Oberflächen der Substrate zu den mit Abstand hierzu angeordneten Heizflächen der Heizeinrichtungen frei.

Durch eine Reduzierung der Fläche der Substrate, die von der Aufnahmeeinrichtung kontaktiert wird, wird eine unerwünschte Kontamination der Substrate reduziert. Durch die beschriebene Vorgehensweise wird außerdem der Durchsatz erhöht, da auf das bisher nach jedem Bondvorgang notwendige und zeitintensive vollständige Aufheizen und Abkühlen der zumindest eine Oberfläche überwiegend bedeckenden Aufnahmeeinrichtung verzichtet werden kann.

Ein weiterer Aspekt der erfindungsgemäßen Ausführungsform besteht darin, dass eine Erwärmung des Substratstapels beidseitig zumindest während des Heizens bis zur Bondtemperatur zumindest überwiegend durch Wärmestrahlung erfolgt. Dies wird insbesondere durch Beabstandung der Oberflächen der Substrate von den Heizflächen bewirkt.

Indem der Abstand während des Heizens reduziert wird, nimmt die durch Wärmestrahlung eingebrachte Wärmeleistung im Verhältnis zur durch Wärmekonvektion eingebrachten Wärmeleistung zu. Sobald die Heizflächen, bevorzugt gleichzeitig, die jeweilige Oberfläche der Substrate kontaktieren, wird die Wärmeleistung zumindest teilweise, vorzugsweise überwiegend, durch Wärmeleitung zwischen den Oberflächen und den Heizflächen übertragen. Bevorzugt wird die Bondtemperatur zumindest zu ¾ erreicht, bevor die Wärmeleitung und/oder Druckbeaufschlagung erfolgt.

Eine mögliche Wärmekonvektion von oben und unten hat den Vorteil, dass vorhandene Unebenheiten die ein gleichmäßiges und vorteilhaftes Erwärmen der Substrate erschweren während dem Bondvorgang stark reduziert bzw. gänzlich ausgeschlossen werden können.

In einer besonderen, insbesondere erfindungsgemäß eigenständigen, Ausprägung des Probenhalters und/oder der Heizflächen weisen diese Noppen auf, um eine möglichst geringe Kontaminierung der Oberflächen der Substrate zu erreichen. Dadurch besteht außerdem die Möglichkeit, auch während der Druckbeaufschlagung das für die Konvektion notwendige Gas zuzuführen.

Die Kontaktflächen der Noppen können insbesondere bombiert ausgebildet sein, um die Kontaktfläche der Heizflächen zu den Oberflächen der Substrate weiter zu reduzieren.

Die Noppenfläche wird in einer bevorzugten Ausführungsform weitergebildet, indem der gesamte radiale Umfangsbereich der Heizfläche oder Druckbeaufschlagungsfläche durch einen Dichtring begrenzt ist/wird. Hierdurch wird ein Entweichen des in die Noppendruckplatte geleiteten Gases verhindert bzw. reduziert. Der Umfangsbereich der oberen und unteren Noppendruckplatte schließt insbesondere formschlüssig mit dem zu bearbeitenden Substrat ab und verhindert somit ein Entweichen des Gases.

Erfindungsgemäß denkbar ist es, einen Durchlass vorzusehen, der sich vorteilhafterweise zwischen dem den gesamten radialen Randbereich begrenzenden Steg und dem zu bearbeitenden Substrat erstreckt und über den es möglich ist, überschüssiges Gas, insbesondere kontrolliert, vorzugsweise in Form eines Ventils, aus der Noppenfläche zu entlassen.

Prozessbeschleunigende Maßnahmen wie die kontaminierungsreduzierende automatisierte Übergabe der in der Ausrichtungseinheit ausgerichteten Substrate durch einen sich innerhalb einer Vakuumtransferstrecke befindlichen Prozessroboter mit einer speziell ausgeprägten Aufnahmeeinrichtung, insbesondere in Form einer Auflage, die eine Berührung des Substrats nur an dem Radialumfang vorsieht, ist bisher nicht bekannt. Diese Aufnahmeeinrichtung kann darüber hinaus zusätzlich mit einer elektrostatischen Kraft beaufschlagt werden, um die Haltekräfte des Prozessroboters weiter zu erhöhen.

Auch sind der Ausrichtung vor- und/oder nachgeschaltete Prozesse wie das Temperieren der Substrate als vorteilhafte Ausführung der Erfindung anzusehen, um Oberflächengase und/oder Feuchtigkeit vor dem Einbringen in die Vakuumbondeinrichtung auszutragen und somit das Bondergebnis zu verbessern.

Als weitere, insbesondere eigenständige Erfindung wird eine durchgehende Behandlung von der Ausrichtung bis zum Bonden in einem sich durch alle, insbesondere modularisierten, Komponenten fortsetzenden Vakuum, insbesondere Hochvakuum, offenbart, bei dem sowohl Fremdatome als auch Reaktionen des Substratmaterials, insbesondere Oxidation, weitestgehend ausgeschlossen werden.

Ein weiterer Vorteil der erfindungsgemäßen Ausführungsformen ist die Erhöhung der Präzision eines durchgeführten Bonds. Darunter wird verstanden, dass die durch die Ausrichtungseinheit erreichte Positionierungsgenauigkeit mehrerer Strukturen der Substrate zueinander nicht durch die Wärmebehandlung im Bonder verloren geht. Verformungen treten im Stand der Technik insbesondere dadurch auf, dass inhomogen erwärmte Substratstapel, beispielsweise auf Grund von Substraten aus unterschiedlichen Materialien und damit unterschiedlichen thermischen Ausdehnungskoeffizienten, sich verschieben oder verformen, bevor der Bondvorgang abgeschlossen wird, also der Prozess der Druckbeaufschlagung, beginnt oder stattfindet. Die Erfindung erlaubt dagegen die Beibehaltung der Justiergenauigkeit der Ausrichtungseinrichtung zwischen mehreren Strukturen bis und über den eigentlichen Bondprozess hinaus. Die erreichte und beibehaltene Ausrichtungsgenauigkeit, also die maximale Verschiebung zwischen den Strukturen an den gegenüberliegenden Substraten des ausgerichteten Substratstapels bis zum Abschluss des Bondens ist erfindungsgemäß insbesondere kleiner als 10 µm, mit Vorzug kleiner als 1 µm, mit größerem Vorzug kleiner als 100 nm, mit größtem Vorzug kleiner als 10 nm.

Die erfindungsgemäße Ausführungsform erlaubt im isothermen Betrieb eine Steigerung des Durchsatzes, da die Heizer und damit der Probenhalter sowie die Druckplatten bevorzugt nicht ständig geheizt und gekühlt werden, sondern, insbesondere zumindest überwiegend, vorzugsweise ausschließlich, durch Positionsänderung eine Temperaturänderung am Substratstapel bewirken können. Bauteile des Bonders, insbesondere mindestens eine der Druckplatten, können sich quasi bei voller Bondtemperatur in eine Stand-By-Position bewegen und dort auf den nächsten Substratstapel warten, ohne gekühlt werden zu müssen.

Die Kontamination der Substrate des Substratstapels ist geringer, da der Substratstapel zumindest überwiegend an den zu heizenden Oberflächen bis zur Druckbeaufschlagung nicht aufliegt, sondern in Schwebe gehalten wird und somit praktisch keine Kontakt mit Kontaminationsmaterial hat. Bei dem Kontakt zur Druckbeaufschlagung wird erfindungsgemäß mit Vorzug ein Noppenprobenhalter, insbesondere auch als Druckplatte und/oder Heizfläche, verwendet, der die wirksame Kontaktfläche zu den Substraten sogar bei der Druckbeaufschlagung minimiert. Die Kontaktfläche des Noppenprobenhalters ist erfindungsgemäß insbesondere kleiner als 90%, mit Vorzug kleiner als 50%, mit größerem Vorzug kleiner als 25%, mit größtem Vorzug kleiner als 5%, mit allergrößtem Vorzug kleiner als 1% der Substratfläche.

Die Erfindungsgemäße Vorrichtung besteht insbesondere aus einer modular aufgebauten Einrichtung/Anlage, welche in einer ersten Ausführungsform aus mindestens drei unabhängig voneinander zu steuernden Modulen, nämlich einer Ausrichtungseinheit (engl.: aligner), einer Vakuumtransferstrecke mit integrierter Handhabungseinrichtung, insbesondere dem Prozessroboter zur Handhabung von Substraten, sowie einer Bondeinheit besteht. Möglich ist aus verfahrenstechnischen Gründen eine Ergänzung durch weitere Module. Insbesondere können manche Module zur Beschleunigung und parallelen Bearbeitung mehrfach vorgesehen sein.

Die Beschickung der Ausrichtungseinheit mit den mindestens zwei auszurichtenden Substraten erfolgt manuell, kann aber bevorzugt semiautomatisch oder noch bevorzugter vollautomatisiert erfolgen.

Bei den Substraten handelt es sich mit Vorzug um Wafer. Die Wafer sind genormte Halbleitersubstrate mit wohldefinierten, standardisierten Durchmessern. Die Substrate können jede beliebige Form besitzen. Insbesondere können die Substrate rechteckig oder rund sein. Sollten die Substrate rund sein, können die Durchmesser der Substrate ebenfalls jede beliebige Größe haben, besitzen aber meistens einen der genormten Durchmesser von 1, 2, 3, 4 Zoll sowie 125, 150, 200, 300 oder 450 mm.

Im weiteren Verlauf der Patentschrift wird allgemein von Substraten gesprochen. Insbesondere beziehen sich die erfindungsgemäßen Ausführungsformen allerdings vorwiegend auf Wafer.

Die Substrate werden zueinander ausgerichtet und bilden einen Substratstapel. Der Substratstapel besteht aus mindestens zwei Substraten. Es können aber auch mehr als zwei, mit Vorzug mehr als fünf, mit größerem Vorzug mehr als zehn, mit größtem Vorzug mehr als 15 Substrate zueinander ausgerichtet und temporär zu einem Substratstapel verbunden werden. Die Substrate können aus jedem beliebigen Material bestehen. Vorzugsweise handelt es sich um Materialien, die in der Halbleiterindustrie verwendet werden. Dazu zählen bevorzugt Halbleiter wie Silizium, Germanium, Gläser wie beispielsweise Quarz, Halbleiterheterostrukturen wie GaAs oder Keramiken. Denkbar wäre auch noch die Verwendung von Polymersubstraten oder Metallsubstraten. Die Dicken der Substrate variieren zwischen 10000 µm und 50 µm, wobei Substrate mit entsprechend geringen Dicken durch Schleif- und Polierprozesse auf die jeweilige Dicke hergestellt werden. Trägersubstrate, die nur zur Unterstützung anderer Substrate, der sogenannten Produktsubstrate dienen, haben hohe Dicken, wohingegen Produktsubstrate immer stärker gedünnt werden, um eine entsprechend hohe Packungsdichte funktionaler Einheiten auf den Produktsubstraten durch Stapelung zu erreichen. Die Dicke eines Trägersubstrats ist größer als 200 µm, mit Vorzug größer als 500µm, mit größtem Vorzug größer als 700µm, mit allergrößtem Vorzug größer als 1000µm. Die Dicke eines Produktsubstrats ist kleiner als 1000 µm, mit Vorzug kleiner als 500 µm, mit größerem Vorzug kleiner als 100 µm, mit allergrößtem Vorzug kleiner als 50 µm.

Die Ausrichtungseinheit ist außerdem mit einer Vorrichtung zur Aufnahme und Fixierung der Substrate ausgestattet, die es erlaubt Substrate nach der Ausrichtung zueinander zu fixieren.

Insbesondere umfasst die Ausrichtungseinheit eine Vorrichtung, die es erlaubt, Substrate gegeneinander auszurichten und so mit einem Fixiermittel temporär zu fixieren, dass ein Transport von der Ausrichtungseinheit über eine Vakuumtransferstrecke hin zu einem weiteren Modul, insbesondere einer Bondeinrichtung, möglich ist, ohne dass dieser Transport sich negativ auf die ausgerichteten Substrate auswirkt. Mit besonderem Vorzug handelt es sich bei der Fixiereinheit um eine Vorrichtung zur magnetischen Fixierung des Substratstapels, wie in der Druckschrift PCT/EP 2013/056620 beschrieben, auf die insofern Bezug genommen wird. Die Klemmung kann alternativ durch mechanische Klemmen erfolgen, welche die Seiten der Substrate in einem kleinen Umfangsabschnitt umklammern und nicht mehr an einen Probenhalter fixiert sein müssen. Denkbar wäre auch die Fixierung der Substrate untereinander durch eine elektrostatische Anziehungskraft zwischen den Oberflächen der Substrate. Eine weitere denkbare Möglichkeit, die Substrate miteinander zu fixieren, stellt das Tacken (Heften) dar. Dabei handelt es sich um ein lokales Verschweißen oder Verkleben der beiden Substrate durch die Aufbringung einer konzentrierten Punktkraft, insbesondere eines konzentrierten elektrischen Stroms oder einer stark begrenzen sehr heißen Wärmebeaufschlagung, vorzugsweise durch einen Laser. Diese örtlich begrenzte Beanspruchung zwischen den Oberflächen der beiden Substrate sorgt zumindest für eine lokale Fixierung, die ausreicht, um die beiden Substrate transportieren zu können, ohne eine Verschiebung der beiden Substrate zueinander zu verursachen.

Erfindungsgemäß sind die einzelnen Module insbesondere mit Verbindungsschleusen ausgestattet, die sich an den jeweiligen Übergängen zu den einzelnen Modulen befinden und mit denen die Möglichkeit besteht, definierte, den weiteren Prozess positiv beeinflussende Atmosphären zu schaffen.

Erfindungsgemäß ist eine Schleuse ein Bereich, insbesondere ein Raum, der durch zwei Schleusentore von zwei weiteren, voneinander getrennten, aber mit der Schleuse verbundenen, Bereichen, insbesondere Räumen, verbunden ist. Der Zugang aus und/oder von der Schleuse in und/oder von einem der beiden Räume erfolgt durch Schleusentore. Die Schleusentore sind insbesondere einzeln ansteuerbar. Die Schleusentore sind insbesondere als Ventile oder Torventile (engl.: gate valve) ausgebildet. Im weiteren Verlauf wird nicht explizit zwischen Schleusentor und/oder Schleuse unterschieden. Damit ist gemeint, dass bei der Verwendung des Wortes Schleusentor insbesondere auch eine gesamte Schleuse, daher ein Bereich, insbesondere ein Raum, mit zwei Schleusentoren gemeint sein kann.

In den einzelnen Modulen ist es demnach möglich, unterschiedliche Atmosphären in Abhängigkeit der Anforderungen an den jeweiligen Prozess zu erzeugen. Außerdem ist es möglich, in dem Vakuumtransfermodul Prozesse zu steuern, die eine Beschleunigung des gesamten Bondvorgangs ermöglichen. Denkbar ist hierbei eine dem Bonden vorgeschaltete Erwärmung, die es ermöglicht, zu bondende Substrate vorzuheizen, um diese in der Folge temperiert an das Vakuumkammermodul zu übergeben. Dadurch wird das zeitintensive Aufheizen der Heizeinrichtungen des Bondeinrichtung signifikant verkürzt, was sich unmittelbar auf den zu erwartenden Durchsatz auswirkt.

Zusätzlich denkbar ist insbesondere eine vorgeschaltete Erwärmung zur Vorkonditionierung der Substrate unabhängig voneinander. Die Substrate können vor der Einbringung in die Ausrichtungseinheit auf vorzugsweise >100°C geheizt werden. Dabei ist die freie Weglänge für Moleküle an der Oberfläche maximierbar. Zum Beispiel können die Substrate mit großem Abstand zu einer Kammerwand (>1cm, >5cm, >10cm) erhitzt werden. Die dadurch entstehende große freie Weglänge fördert den Abtransport von Fremdatomen und Gasen von der Oberfläche der Substrate. Beim Transport der einzelnen Substrate in die Ausrichtungseinheit fallen die Temperaturen vorzugsweise wieder auf Raumtemperatur.

Die Ausrichtung der Substrate geschieht in der Ausrichtungseinheit insbesondere unter Hochvakuumbedingungen, die bevorzugt im Wesentlichen den Druckbedingungen in der Bondeinrichtung entsprechen. Nach Ausrichtung der Substrate erfolgt ein automatisierter Transport über einen Prozessroboter von der Ausrichtungseinheit hin zu einem Vakuumtransfermodul, in dem vorbereitende Maßnahmen für das im weiteren Verlauf des Prozesses geplante Bonden vorgenommen werden können.

Nach dem Transfer des Substratstapels von dem Vakuumtransferstreckenmodul in das Bondmodul wird der Substratstapel von dem Roboter auf ausfahrbaren Beladestiften abgelegt. Ein direkter Kontakt zwischen den Beladestiften und dem Substratstapel erfolgt nur partiell. Erfindungsgemäß werden maximal dreißig, vorzugsweise weniger als 20, mit größerem Vorzug weniger als 10, mit größtem Vorzug weniger als 5, am meisten bevorzugt genau drei Beladestifte, verwendet.

Der zu bondende Substratstapel schwebt somit zwischen einer dynamisch an die Substrate heranführbaren ersten Heizfläche und Druckplatte und einer, insbesondere statischen, zweiten Heizfläche. Sowohl die erste (insbesondere obere) als auch die zweite (insbesondere untere) Heizeinrichtung und Druckplatte haben vorteilhafterweise näherungsweise den gleichen Durchmesser wie die zu behandelnden Substrate, oder sind grösser. Die erste Heizfläche und Druckplatte kann sowohl symmetrisch als auch asymmetrisch an die Substrate herangeführt werden. Bei einer asymmetrischen Erwärmung des Substrats ist der Abstand auch während eines dynamischen Heranführens der ersten Heizfläche und Druckplatte an die in der Substrataufnahme befindlichen Substrate ungleich dem Abstand der zweiten Heizfläche und Druckplatte zu der zwischen der ersten und zweiten Heizfläche befindlichen Substrataufnahme bzw. zu den zu heizenden Oberflächen der Substrate.

Der Abstand zwischen der ersten und/oder zweiten Heizfläche und dem Substratstapel während des Beladevorgangs ist insbesondere größer als 1 mm, mit Vorzug größer als 5 mm, mit größerem Vorzug größer als 10 mm, mit größtem Vorzug größer als 30 mm.

Die Temperaturen der ersten und/oder zweiten Heizfläche während des Beladevorgangs sind insbesondere größer als 25°C, mit Vorzug größer als 100°C, mit größerem Vorzug größer als 300°C.

Die Aufheizrate des Substratstapels wird insbesondere durch die Abstände A der ersten Heizfläche und/oder B der zweiten Heizfläche relativ zum Substratstapel beziehungsweise zu den jeweiligen Oberflächen gesteuert werden. Damit ist es erfindungsgemäß insbesondere möglich, Temperaturprogramme und/oder -zyklen zu fahren, ohne die Heizeinrichtungen und damit den Probenhalter und/oder die Druckplatte ständig kühlen oder heizen zu müssen. Eine ähnliche Vorgehensweise wurde bereits in der Patentschrift PCT/EP2013/064151 verwendet, um eine Flüssigkeit durch die Positionierung eines Heizers zu erwärmen, ohne den Heizer ständig heizen bzw. kühlen zu müssen. Durch diese erfindungsgemäße Ausführungsform wird es möglich, einen Heizer auf eine gewisse, insbesondere Bondtemperatur zu heizen, seine Position aber während des Beladevorgangs so weit von der Beladeebene des Substratstapels festzulegen, dass der geladene Substratstapel zunächst (also insbesondere beim Beladen) kaum geheizt wird. Erst durch die Annäherung erfolgt eine entsprechend gesteuerte, nach den Randbedingungen vorgegebene, symmetrische Erwärmung der Substrate. Dieser erfindungsgemäße Prozess funktioniert insbesondere, wenn die Erwärmung des Substratstapels zumindest überwiegend, vorzugsweise ausschließlich, durch Wärmestrahlung, nicht über Wärmekonvektion erfolgt. Insbesondere besitzt dieser erfindungsgemäße Prozess die größte Effektivität unter Vakuum.

Bei einer symmetrischen Erwärmung der Substrate sind der Abstand A während eines dynamischen Heranführens der ersten Heizfläche und Druckplatte an die Substrate gleich dem Abstand B der zweiten, insbesondere statischen, zweiten Heizfläche. Erreicht wird dies insbesondere durch kontrolliertes und insbesondere kontinuierliches Heranführen sowohl der ersten Heizfläche an die zweite Heizfläche, wobei zeitgleich auch die den Substratstapel aufnehmende Aufnahmeeinrichtung an die zweite Heizfläche herangeführt wird. Bevorzugt wird die erste Heizfläche genau doppelt so schnell wie der Substratstapel auf die zweite Heizfläche zu bewegt.

In einer alternativen Ausführungsform bleibt die Aufnahmeeinrichtung mit dem Substratstapel stationär und die beiden Heizflächen bewegen sich, insbesondere mit gleicher Geschwindigkeit und unter gleichen, sich symmetrisch verringernden Abständen A und B, von oben und unten auf den Substratstapel zu.

Sowohl für die symmetrische als auch die asymmetrische Erwärmung werden, insbesondere vorher empirisch oder durch Messungen ermittelte, Rezepte in einer Steuerungseinrichtung hinterlegt, die unter Berücksichtigung vorhandener Parameter für eine optimierte Erwärmung der Substrate sorgen. Als Parameter kommen vor allem die Materialart, Dicke, Aufheiztemperatur und Bondverfahren in Betracht.

Die asymmetrische Annäherung bzw. Positionierung hat vor allem die Aufgabe, einen unterschiedlichen Wärmeeintrag in die Substrate zu ermöglichen, um die thermischen Dehnungen zweier Substrate unterschiedlicher Materialien ausgleichen zu können. Im Allgemeinen hat jedes Material einen eigenen thermischen Ausdehnungskoeffizienten. Um eine gleiche Dehnung beider Substrate zu erzielen, wird in diesem Fall das Substrat mit dem größeren thermischen Ausdehnungskoeffizienten auf eine geringere Temperatur geheizt als das Substrat mit dem geringeren thermischen Ausdehnungskoeffizienten. Dies kann durch unterschiedliche Temperaturen an der ersten Heizfläche und der zweiten Heizfläche und/oder durch unterschiedliche Abstände A und B erfolgen.

Ein weiterer, erfindungsgemäßer Aspekt besteht darin, dass ein Gaseintritt zwischen die Kontaktflächen des Substratstapel nach einer Kontaktierung der ersten Druckplatte und der zweiten Druckplatte oder des Probenhalters mit dem Substratstapel verhindert wird und anschließend ein Gas in die Bondeinrichtung eingeleitet wird. Dieses breitet sich zwischen der rauen Oberfläche des Substratstapels und des Probenhalters bzw. den Druckplatten aus und schließt die Oberflächenunebenheiten thermisch.

Unter thermischen Schließen versteht man, dass das eingeleitete Gas als Wärmeüberträger dient, um die Wärme von den Heizern über den Probenhalter bzw. die Druckplatte so schnell wie möglich in den Substratstapel einzubringen. Der Gasdruck zwischen Probenhalter und Substratstapel ist dabei insbesondere >0,01 mbar, mit Vorzug >0,1 mbar, mit großem Vorzug >lmbar, mit allergrösstem Vorzug >3mbar. Dieser Gasdruck wird insbesondere durch geringe Gasmengen (Flussrate) erreicht, vorzugsweise von >1 sccm, noch bevorzugter >5sccm, noch bevorzugter >20 sccm.

Durch hohe Pumpleistung, insbesondere von mehreren hundert Litern pro Sekunde, kann gleichzeitig ein hohes Vakuum in der Bondkammer, insbesondere <0,001mbar, bevorzugt <0,0001mbar, noch bevorzugter <0,00001mbar, aufrechterhalten werden.

Dabei wirkt insbesondere eine Kraft auf den Substratstapel, die eine laterale Verschiebung verhindert. Die aufgebrachten Bondkräfte liegen bevorzugt zwischen 1 N und 200kN, mit größerem Vorzug zwischen 1kN und 100kN.

Von diesem Zeitpunkt an erfolgt ein gewöhnlicher, im Stand der Technik bereits bekannter Bondvorgang. Dabei kann es sich um einen Temporärbond oder einen Permanentbond handeln. Denkbar wären Temporärbonds mit Temporärklebern, Permanentbonds wie eutektische Bonds, anodische Bonds, Glassfrittbonds, Fusionbonds, Metall(diffusions)bonds oder mit Permanentklebern.

Obwohl die erfindungsgemäße Ausführungsform sowie der erfindungsgemäße Prozess mit nahezu allen Probenhaltern durchgeführt werden kann, wird ein Noppenprobenhalter bevorzugt (eigenständiger Erfindungsaspekt). Unter einem Noppenprobenhalter versteht man einen Probenhalter, dessen Oberfläche nicht eben ist, sondern aus mehreren kleinen Erhebungen, den Noppen, besteht, welche eine Halteebene bilden und darauf den Substratstapel tragen. Diese Noppen reduzieren die Kontaktfläche zum Substratstapel erheblich und verringern damit auch die Wahrscheinlichkeit der Kontamination des Substrats. Der Noppenprobenhalter wird so ausgeführt, dass er die aufgebrachte Bondkraft übersteht.

Die Höhe der Noppen ist insbesondere kleiner als 1 mm, mit Vorzug kleiner als 0.1 mm, mit größerem Vorzug kleiner als 0.01 mm, mit größtem Vorzug kleiner als 0.001 mm. Mit besonderem Vorzug besitzt auch die Druckplatte Noppen, sodass es sich bei der Druckplatte um eine Noppendruckplatte handelt, welche die gleiche erfindungsgemäße Eigenschaft besitzt wie der Noppenprobenhalter.

In einer weiteren, besonderen Ausführungsform besitzt mindestens eine der Heizeinrichtungen, vorzugsweise die gleichzeitig als Probenhalter ausgebildete, eine aus mehreren Zonen bestehende Heizfläche. Diese Zonen der Heizfläche können bevorzugt einzeln angesteuert werden. Die Zonen des Heizers sind mit Vorzug konzentrisch zueinander positionierte Kreisringe. Durch das gezielte Ansteuern der Zonen können örtlich aufgelöste Temperaturprofile erzeugt werden. Die Anzahl der Zonen ist größer als 1, mit Vorzug größer als 5, mit größerem Vorzug größer als 10, mit größtem Vorzug größer als 20, mit größtem Vorzug größer als 50, mit allergrößtem Vorzug größer als 100.

Bei allen beschriebenen Modulen handelt es sich um solche, in denen besondere Atmosphären in Abhängigkeit des Materials der Substrate als auch der Anforderungen für das jeweilige Bondverfahren reproduzierbar herstellbar sind. Außerdem sind die Module unabhängig voneinander, insbesondere stufenlos, regelbar. Alternativ können die einzelnen Module auch ohne ein Vakuum, also mit Normaldruck, betrieben werden. Auch ist eine atmosphärische Synchronisierung von zwei nebeneinanderliegenden Modulen möglich, um ein beschleunigtes Bewegen von Substraten von einem Modul in ein innerhalb des Prozesses nachgeschaltetes Modul zu ermöglichen.

Der Druck innerhalb der Vakuumstrecke und/oder innerhalb der Ausrichtungseinrichtung und/oder innerhalb der Bondeinrichtung ist insbesondere kleiner als 1 mbar, mit Vorzug kleiner als 10⁻³ mbar, mit größerem Vorzug kleiner als 10⁻⁵ mbar, mit größtem Vorzug kleiner als 10⁻⁷ mbar, mit allergrößtem Vorzug kleiner als 10⁻⁹ mbar.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: eine schematische Aufsicht einer ersten Ausführungsform eines Vakuumclusters mit genau zwei angehängten Modulen,
- Figur 1b: eine schematische Aufsicht einer zweiten Ausführungsform eines Vakuumclusters mit sieben angehängten Modulen,
- Figur 2: einen schematischen Querschnitt einer erfindungsgemäßen Ausführungsform einer Bondeinrichtung vor dem Laden eines Substratstapels,
- Figur 3: einen schematischen Querschnitt der Ausführungsform gemäß Figur 2 beim Absetzen des Substratstapels auf Beladestifte,
- Figur 4: einen schematischen Querschnitt der Ausführungsform gemäß Figur 2 bei der Entfernung eines Roboterarms vom Substratstapel,
- Figur 5: einen schematischen Querschnitt der Ausführungsform gemäß Figur 2 bei der Entfernung des Roboterarms aus dem Modul,
- Figur 6: einen schematischen Querschnitt der Ausführungsform gemäß Figur 2 beim symmetrischen Heizen des Substrats mit zwei Heizeinrichtungen,
- Figur 7: einen schematischen Querschnitt der Ausführungsform gemäß Figur 2 bei der symmetrischen Annäherung der Heizeinrichtungen relativ zum Substratstapel,
- Figur 8: einen schematischen Querschnitt der Ausführungsform gemäß Figur 2 bei der symmetrischen Annäherung der Heizeinrichtung relativ zum Substrat mit Kontakt der ersten Heizeinrichtung mit Teilen der erfindungsgemäßen Beladestifte,
- Figur 9: einen schematischen Querschnitt der Ausführungsform gemäß Figur 2 bei der symmetrischen Kontaktierung des Substratstapels,
- Figur 10: eine Seitenansicht eines Querschnitt der Umgebung eines Noppenprobenhalters und einer Noppendruckplatte,
- Figur. 11: eine Oberansicht eines erfindungsgemäßen Noppenprobenhalters und .
- Figur. 12: eine Oberansicht einer erfindungsgemäßen Noppendruckplatte.

In den Figuren sind gleiche oder gleichwirkende Merkmale mit den gleichen Bezugszeichen gekennzeichnet.

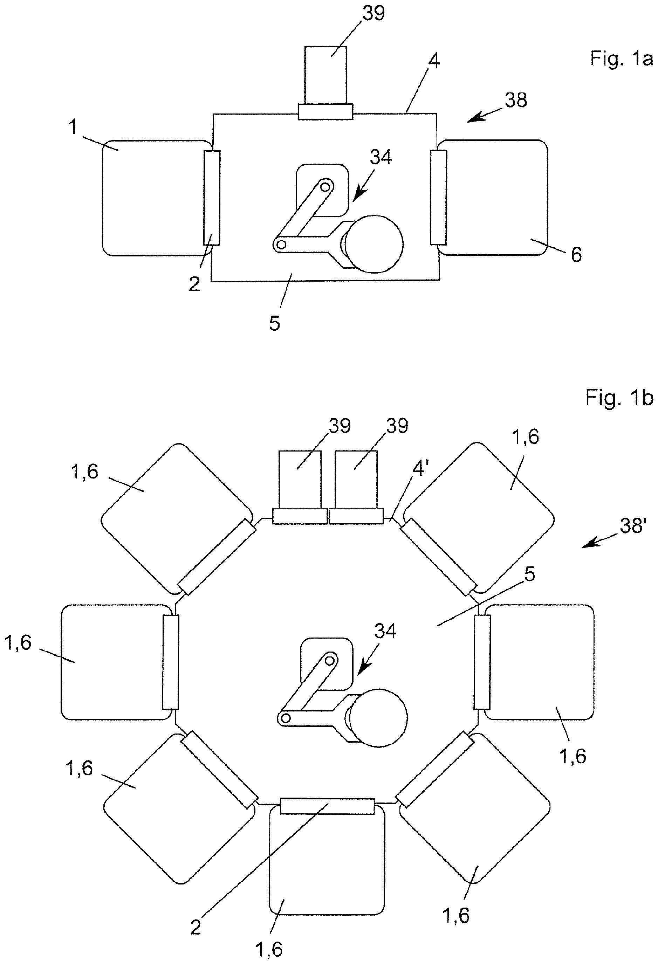

Die Figur 1a zeigt eine schematische Aufsicht einer, insbesondere als Vakuumcluster, vorzugsweise als Hochvakuumcluster, ausgeführten, Anlage 38. Die Anlage 38 besteht aus genau zwei an eine Vakuumtransferkammer 4 angehängten Modulen, einem Modul mit einer Ausrichtungseinrichtung 1 und einem Modul mit einer erfindungsgemäßen Bondeinrichtung 6. Ein, insbesondere als Prozessroboter ausgeführter, Roboter 34 entnimmt (hier identische) Substrate 35, 36 aus einem Ladebehälter 39 und transportiert das erste Substrat 35 und das zweite Substrat 36, insbesondere gleichzeitig, entlang einer Vakuumtransferstrecke 5 in die Ausrichtungseinheit 1. Der Ladebehälter 39 kann insbesondere auch eine Schleuse sein bzw. als solche wirken. Die beiden Substrate 35, 36 werden zueinander ausgerichtet und an einer ersten Kontaktfläche 35k des ersten Substrats 35 und einer zweiten Kontaktfläche 36k des zweiten Substrats 36 zu einem Substratstapel 14, insbesondere temporär, fixiert. Als Ausrichtungseinheit könnten beispielsweise die Anlagen aus den Patentschriften PCT/EP 2013/075831 oder aus PCT/EP 2013/062473 verwendet werden. Eine optimale Ausrichtung ist dann gegeben, wenn die aneinander auszurichtenden Strukturen, insbesondere auch die Ausrichtungsmarken, gemäß dem in der Industrie bekannten overlay Modell optimal zueinander passen. Eine entsprechende Beschreibung eines solchen overlay Modells findet sich in der Patentschrift PCT/EP 2013/061086.

Anschließend transportiert der Roboter 34 den fixierten und ausgerichteten Substratstapel 14 in die Bondeinrichtung 6, insbesondere durch Aufnahme an einer ersten Oberfläche 35o des ersten Substrats 35 oder an einer zweiten Oberfläche 36o des zweiten Substrats 36. Die Oberflächen 35o, 36o sind jeweils von den Kontaktflächen 35k, 36k abgewandt.

Die Anlage 38' gemäß Figur 1b zeigt einen Vakuumcluster, der aus mehreren, durch eine Vakuumtransferkammer 4' verbundenen Modulen besteht. Die Module können sich in ihrer Funktionalität untereinander unterschieden. Denkbar sind insbesondere Module zum Erwärmen oder Kühlen von Substraten bzw. Substratstapeln, Reinigungsmodule, Plasmamodule, Belackungsmodule mit Schleuderbelackern oder Sprühbelackern, Bonder 1 und Debonder, Beschichtungsmodule, Ausrichtungsmodule 6. Die Module werden mit Vorzug kreisförmig bzw. sternförmig um eine Vakuumtransferkammer 4' angeordnet.

Die Vakuumtransferkammer 4' ist über Ventile 2 mit den verschiedenen Modulen verbunden. Die Module sowie die Vakuumtransferkammer 4' können durch die Ventile 2 unabhängig voneinander evakuiert werden, befinden sich aber mit Vorzug immer auf dem gleichen Vakuumlevel, bevorzugt dem Hochvakuumlevel der Bondeinrichtung 6.

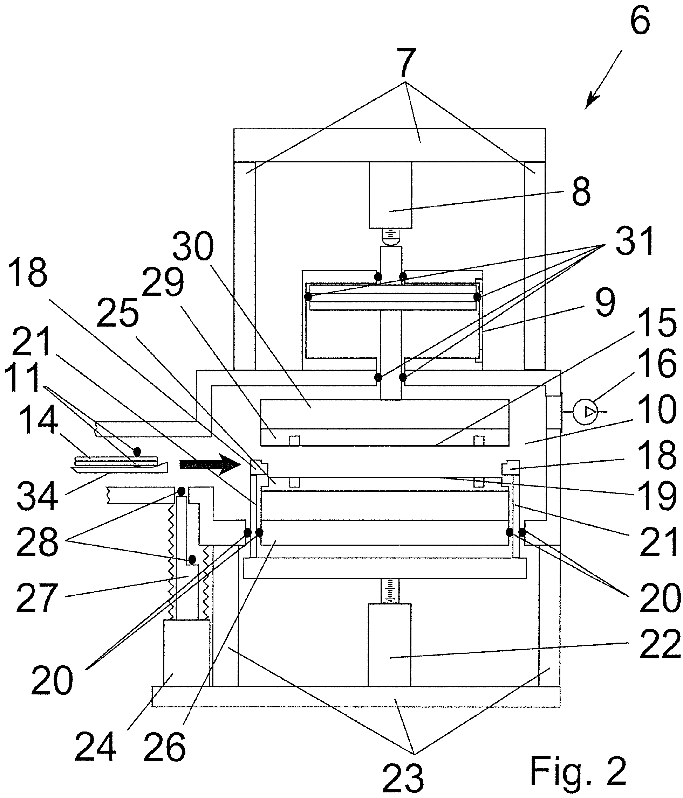

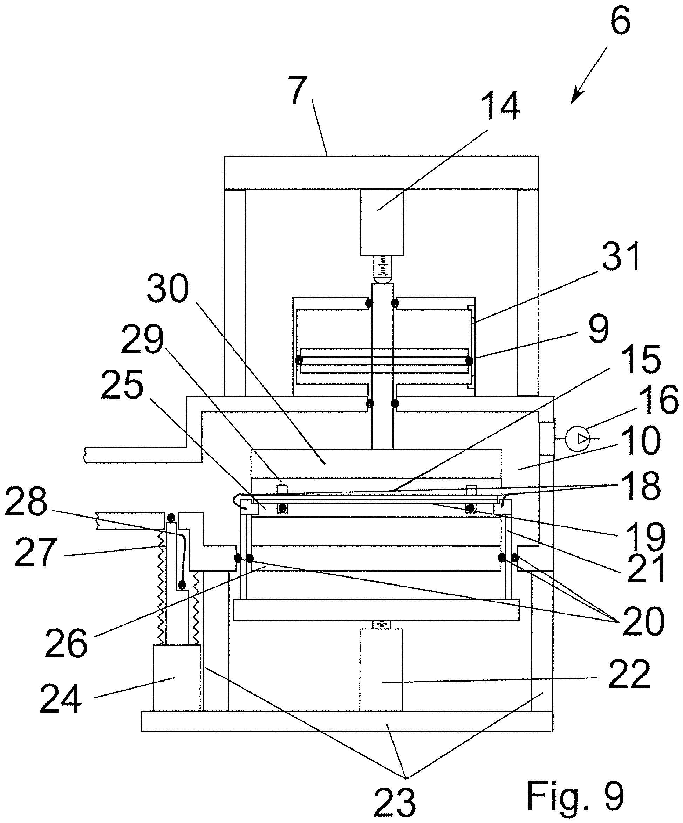

Die Bondeinrichtung 6 ist in den Figuren 2 bis 9 in verschiedenen Bearbeitungszuständen dargestellt.

Die Bondeinrichtung 6 ist auf einer statischen Tragkonstruktion 23 in Form einer Bodenplatte und auf der Bodenplatte fixierten Säulen aufgebaut. Auf den Säulen ist die Bondkammer 10 fixiert.

Die Bondkammer 10 weist eine mit dem Ventil 2 verschließbare Kammeröffnung 6o zum Beladen der Bondkammer 10 auf.

Das Ventil 2 wird gebildet aus einem an der Bodenplatte abgestützten, Schleusenantrieb 24, insbesondere in Form eines Aktuators. Der Schleusenantrieb 24 dient zum Öffnen und Schließen eines von dem Schleusenantrieb 24 angetriebenen Schleusentors 27, das die Kammeröffnung 6o durch einen Schlitz 6s öffnet und schließt. Das Ventil 2 weist Dichtungen 28 zum Abdichten der Bondkammer 10 gegenüber der Umgebung im geschlossenen Zustand des Ventils 2 auf.

Weiterhin umfasst die Bondeinrichtung 6 eine Aufnahmeeinrichtung 18 zur Aufnahme des Substratstapels 14. Die Aufnahmeeinrichtung 18 umfasst eine Substratauflage mit einer Auflageebene E, auf der der Substratstapel 14 mit der zweiten Oberfläche 36o abgelegt wird, so dass die zweite Oberfläche 36o in der Auflageebene E liegt.

Die Substratauflage wird gebildet durch mindestens zwei die Bondkammer 10 durchsetzende Beladestifte 21, im gezeigten Ausführungsbeispiel vier Beladestifte 21. Die Bondkammer 10 ist durch die Beladestifte 21 umschließende Dichtungen 20 gegenüber der Umgebung der Bondkammer 10 abgedichtet. Die Dichtungen 20 dienen gleichzeitig zur gleitenden, translatorischen Führung der Beladestifte 21.

Am der Substratauflage gegenüberliegenden Ende der Beladestifte 21 sind diese auf einer, insbesondere gemeinsamen, Stellplatte 21p fixiert. Die Beladestifte 21 sind mit Vorzug durch die Stellplatte 21p mechanisch miteinander gekoppelt und werden durch einen auf die Stellplatte 21p, insbesondere zentrisch, einwirkenden Stellantrieb 22, bevorzugt in Form eines einzigen, alternativ mittels mehrerer Beladestiftaktuator(en), translatorisch quer zur Auflageebene E bewegt.

Innerhalb der Beladestifte 21 ist eine zweite Heizeinrichtung 26 zum Heizen der zweiten Oberfläche 36o und eine auf der zweiten Heizeinrichtung 26, insbesondere vollflächig, fixierte zweite Druckplatte 25 angeordnet. Die zweite Druckplatte 25 weist eine zweite Heizfläche 19 auf, die unterhalb der Auflageebene E parallel zu dieser anordenbar ist. Die Heizeinrichtung 26 und die Druckplatte 25 sind fix mit der Bondkammer 10 verbunden und statisch, also nicht gegenüber der Auflageebene E beweglich.

Gegenüberliegend zur zweiten Heizfläche 19 ist eine erste Heizfläche 15 parallel zur Auflageebene E und oberhalb dieser anordenbar. Die erste Heizfläche 15 ist an einer ersten Druckplatte 29 angeordnet, die wiederum an einer ersten Heizeinrichtung 30, insbesondere vollflächig, fixiert ist.

Die Heizeinrichtung 30 ist durch Antriebsmittel quer zur Auflageebene verstellbar. Die Heizeinrichtung 30 an einer die Bondkammer 10 durchsetzenden Stellstange fixiert. Die Stellstange wird am der Heizeinrichtung 30 gegenüberliegenden Ende von einem Positionsaktuator 8 zur Steuerung der Position, insbesondere eines Abstands A der ersten Heizfläche 15 zu der ersten Oberfläche 35o, der ersten Heizfläche 15 bewegt. Zur Druckbeaufschlagung, insbesondere nach Kontaktierung der ersten Oberfläche 35o mit der ersten Heizfläche 15 und der Kontaktierung der zweiten Oberfläche 36o mit der zweiten Heizfläche 19, dient ein Kraftaktuator 9, der die für das Bonden notwendige, höhere Druckkraft aufbringen kann. Die Bondkammer 10 ist durch die Antriebsmittel abdichtende Dichtungen 31 gegenüber der Umgebung abgedichtet.

Die Antriebsmittel sind an einer Tragkonstruktion 7, bestehend aus einer Deckenplatte und die Deckenplatte tragenden Säulen, aufgehängt.

Der erfindungsgemäße Prozess nachfolgend an Hand der Figuren 2 bis 9 beschrieben.

In einem ersten erfindungsgemäßen Schritt gemäß Figur 2 wird der Roboter 34 mit dem Substratstapel 14 in eine Bondkammer 10 der Bondeinrichtung 6 bewegt, insbesondere eingeschleust. Im ersten Schritt befindet sich die erfindungsgemäße Aufnahmeeinrichtung 18 zur Aufnahme des Substratstapels 14 auf einer Ausgangshöhe. In der Ausgangshöhe ist der Substratstapel 14 bezogen auf die Kontaktflächen 35k, 36k mit Vorzug symmetrisch zur ersten Heizfläche 15 und zur zweiten Heizfläche 29 positioniert. Diese symmetrische Ausgangsposition ist vor allem dann von Bedeutung, wenn die zweite Druckplatte 25 und/oder die erste Druckplatte 29 durch ihre entsprechenden Heizeinrichtungen 26, 30 vorgeheizt wurden.

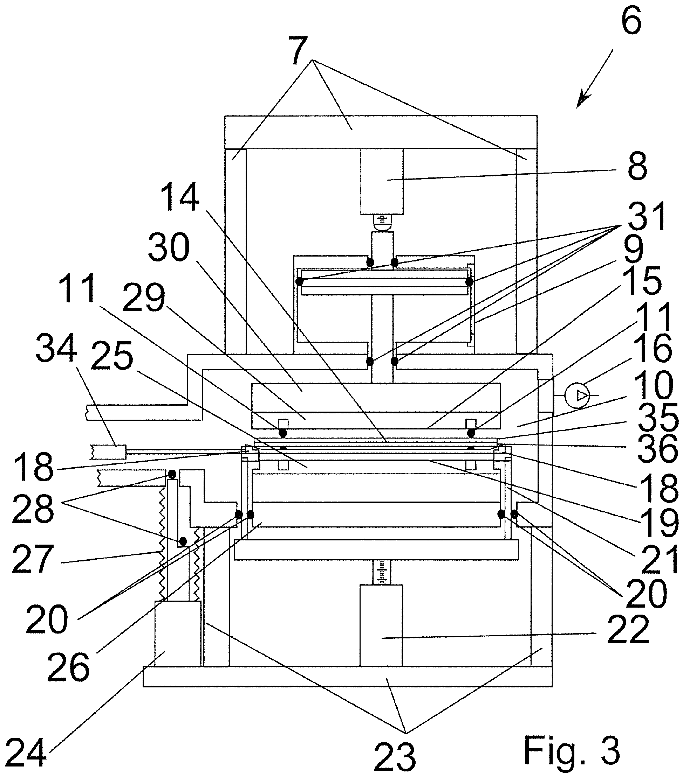

In einem zweiten erfindungsgemäßen Schritt gemäß Figur 3 erfolgt die Positionierung des Substratstapels 14 in einer solchen Position, dass die Fixierungen 11 zur Fixierung des Substratstapels, insbesondere Magnetklemmen 11, beim späteren Zusammenfahren der Heizflächen 15, 19 genau in dafür vorgesehenen Ausnehmungen der Druckplatten 25, 29 aufgenommen werden können.

Des Weiteren ist darauf zu achten, dass der Substratstapel 14 möglichst zentrisch zu den Beladestiften 21 beladen und positioniert wird, um ein Abrutschen oder Verrutschen zu verhindern.

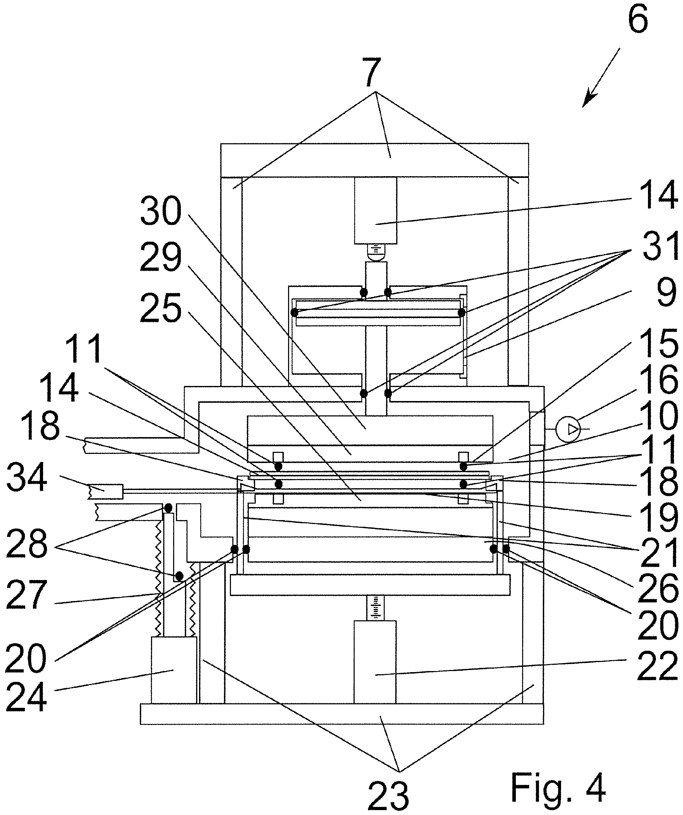

In einem dritten erfindungsgemäßen Schritt gemäß Figur 4 wird der Roboter 34 von dem Substratstapel 14 entfernt, damit der Substratstapel 14 auf den Beladestiften 21 aufliegt. Die zweite Oberseite 36o liegt jetzt in der Auflageebene E.

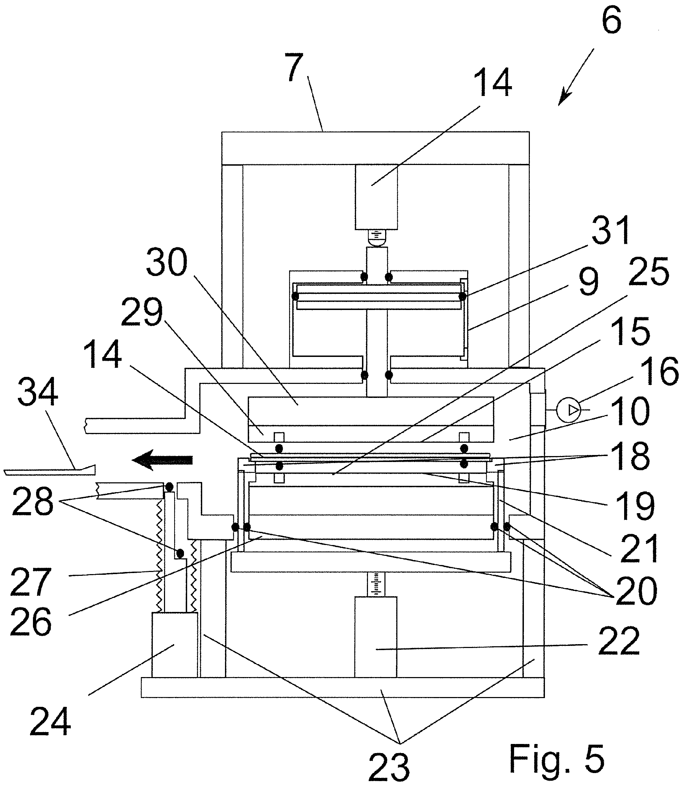

In einem vierten erfindungsgemäßen Schritt gemäß Figur 5 erfolgen die Entfernung des Roboters 34 aus der Bondkammer 10 sowie das Schließen der Schleuse 27. Nach dem Verschließen kann das Innere der Bondeinrichtung 6 über eine Pumpe 16 auf ein noch höheres Vakuum evakuiert werden, sollte das in der angrenzenden Vakuumtransferkammer 4 herrschende Vakuum zu gering für den Bondvorgang eingestellt sein.

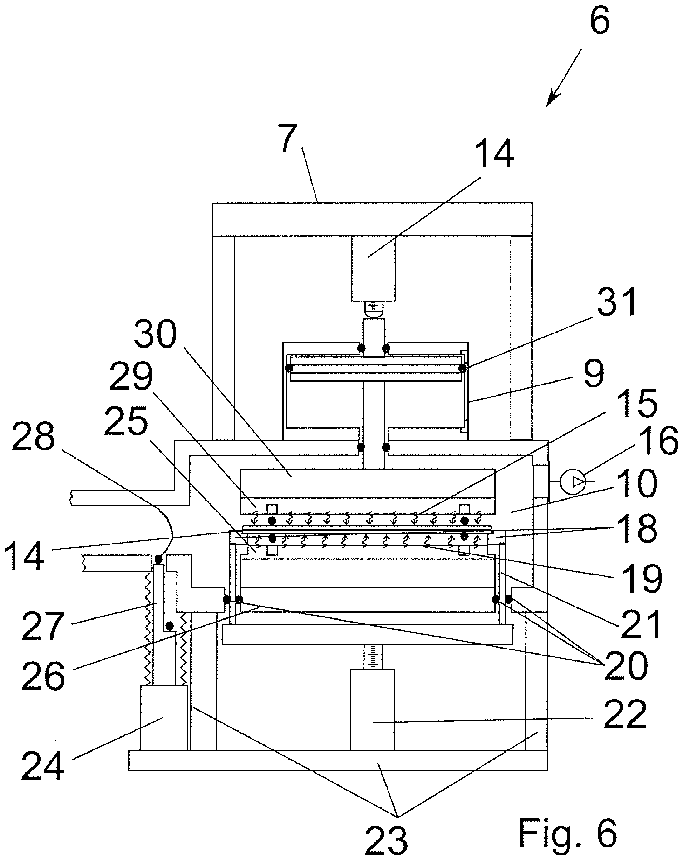

In einem fünften erfindungsgemäßen Schritt gemäß Figur 6 erfolgt nun das symmetrische Aufheizen der beiden voneinander abgewandten Oberflächen 35o, 36o des Substratstapels 14. Denkbar wäre natürlich auch, dass die beiden Heizer 26 und 30 bereits vor dem Einfügen des Substratstapels 14 auf Bondtemperatur eingestellt waren und gehalten wurden, was die Aufheizzeit der Druckplatten 29, 30 und der Heizeinrichtungen 26, 30 praktisch auf Null reduziert.

Das Aufheizen erfolgt durch von den Heizeinrichtungen 26, 30 erzeugte und über die Heizflächen 15, 19 als Strahlungswärme 17 abgegebene Wärmeleistung.

Der erfindungsgemäße Gedanke zeigt sich insbesondere in diesem Prozessschritt. Durch die symmetrische Positionierung des Substratstapels 14 können die Temperaturfelder oberhalb und unterhalb des Substratstapels 14 vollständig äquivalent eingestellt werden, sofern die beiden Heizeinrichtungen 26, 30 mit gleicher Leistung und gleichen Parametern gesteuert werden und die Druckplatten 25, 29 gleiche oder zumindest sehr ähnliche Eigenschaften und Geometrien/Abmessungen aufweisen.

Der Substratstapel 14 ist insbesondere nicht vollflächig durch eine Reibungskraft in seiner radialen thermischen Ausdehnung beschränkt, sondern liegt nur peripher auf den Beladestiften 21 auf. Dadurch kann er sich fast frei schwebend symmetrisch dehnen, ohne dass Spannungen oder Wölbungen verursacht werden.

Ein weiterer gravierender Vorteil besteht darin, dass der Kontakt der beiden Substrate 35, 36 des Substratstapels 14 mit beiden Heizflächen 15, 19 zumindest während des Aufheizprozesses vermieden wird.

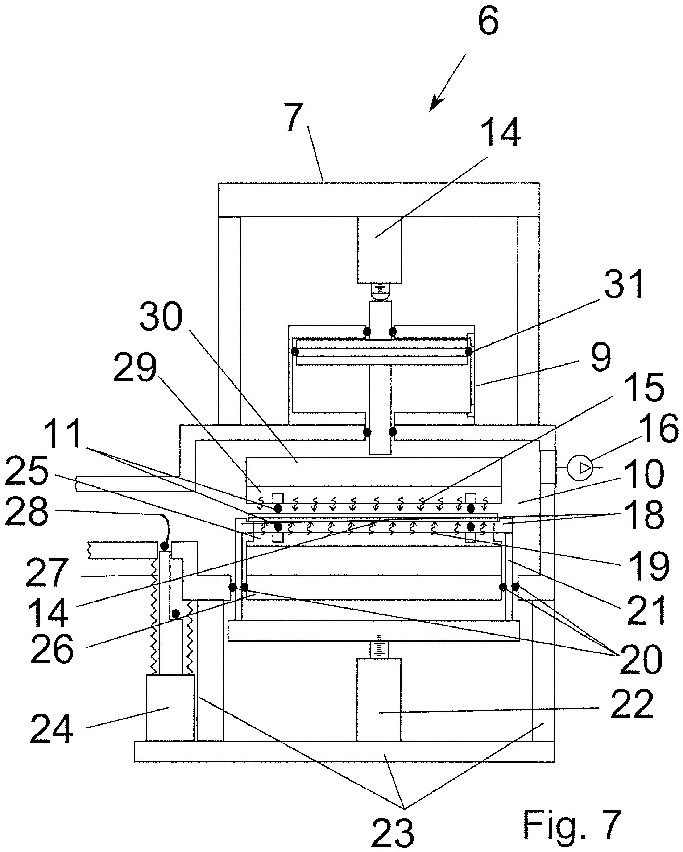

In einem sechsten erfindungsgemäßen Schritt gemäß Figur 7 erfolgt die symmetrische Annäherung des Substratstapels 14 an die zweite Heizfläche 19 und die erste Heizfläche 15. Die zweite Druckplatte 25 (insbesondere Probenhalter) ist dabei statisch und bewegt sich nicht. Vielmehr werden die Beladestifte 21 mittels der Beladestiftaktuatoren 22 auf die erste Heizfläche 15 zu bewegt. Gleichzeitig bewegt sich die erste Heizfläche 15 auf die zweite Heizfläche 19 bzw. den Substratstapel 14 zu.

Um den Abstand A zwischen dem Substratstapel 14 und der ersten Heizfläche 15 gleich dem Abstand B zwischen dem Substratstapel 14 und der zweiten Heizfläche 19 gleich zu halten, wird die erste Heizfläche mit der doppelten Geschwindigkeit der Beladestifte 21 bewegt. Denkbar wäre allerdings auch ein anderes Geschwindigkeitsprofil, um eine gezielte Abstandsfunktion und damit Temperaturfunktion auf den Substratstapel und somit eine zumindest teilweise asymmetrische Annäherung zu realisieren.

Erfindungsgemäß denkbar wäre auch eine Umkehrung, bei dem die erste Heizfläche 15 statisch ausgeführt ist und sich die Beladestifte 21 sowie die zweite Heizfläche 19 in Richtung der ersten Heizfläche 15 bewegen.

In besonderer Ausführungsform wäre auch eine, insbesondere gleich schnelle, gegenläufige, Bewegung der beiden Heizflächen 15, 19 bei statischen Beladestiften 21 denkbar.

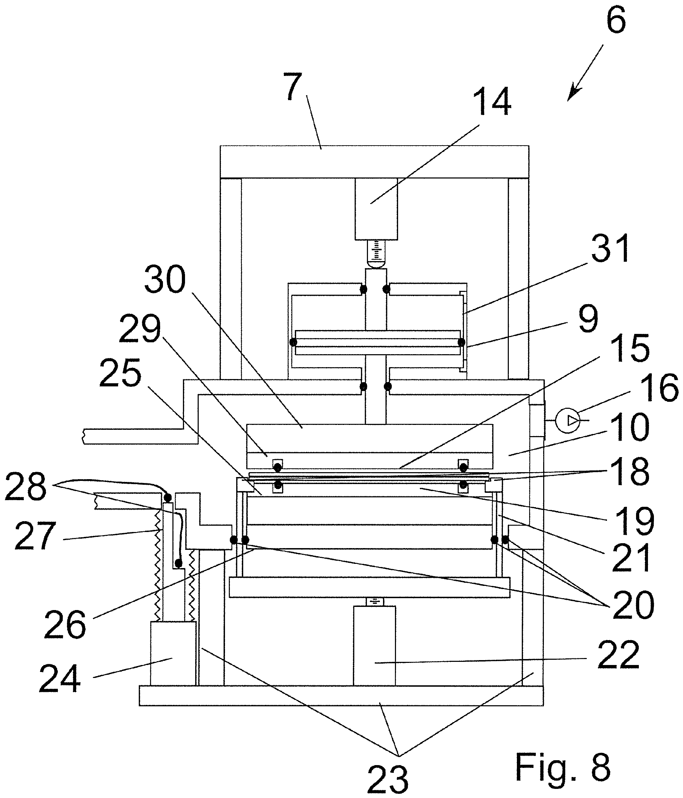

In einem erfindungsgemäß siebten Schritt gemäß Figur 8 erfolgt schließlich die Kontaktierung der Heizflächen 15, 19 mit dem Substratstapel 14. Die hierbei durch den Positionsaktuator 8 aufgebrachte Kraft reicht aus, um die beiden Substrate 35 und 36 so stark aufeinander zu pressen, dass die so erzeugte Reibungskraft eine gegenseitige Verschiebung entlang der Auflageebene E nicht mehr zulässt (Kraftschluss).

Jetzt kann die Bondeinrichtung 6 mit Gas gespült werden.

Vorzugsweise wird das Gas durch Leitungen innerhalb der zweiten Druckplatte 25 und/oder ersten Druckplatte 29 eingeleitet und verteilt sich bei Verwendung einer ersten Druckplatte 29 und/oder zweiten Druckplatte 30 mit Noppen 37 bzw. je einer auf die Druckplatten aufgebrachten zusätzlichen Noppendruckplatte 42, 42' zwischen den Noppen 37 in Strömungskanälen 32.

Gas, das zwischen die Noppen 37 zugeführt wird, kann durch einen die Noppen 37 am Rand der Druckplatte 25, 29 befindlichen und sich über den gesamten radialen Randbereich erstreckenden Steg 40 zurückgehalten werden. Der Steg schließt insbesondere formschlüssig mit dem zu bearbeitenden Substrat 35, 36 an dessen Umfangsrand ab.

Es ist außerdem denkbar, den Steg 40 mit einem einen Durchlass 41 zu versehen, der ein kontrolliertes Entweichen des überschüssigen Gases aus der Noppenfläche ermöglicht. Der Durchlass 41 ist vorteilhafterweise kleiner als 10 µm Durchmesser, mit Vorzug kleiner als 7 µm, mit größerem Vorzug kleiner als 5 µm.

Werden keine Noppen 37 bzw. Noppendruckplatten 42, 42' verwendet, verteilt sich das Gas durch die vorhandene Oberflächenrauigkeit der Heizflächen 15, 19, welche die Noppen 37 ersetzt.

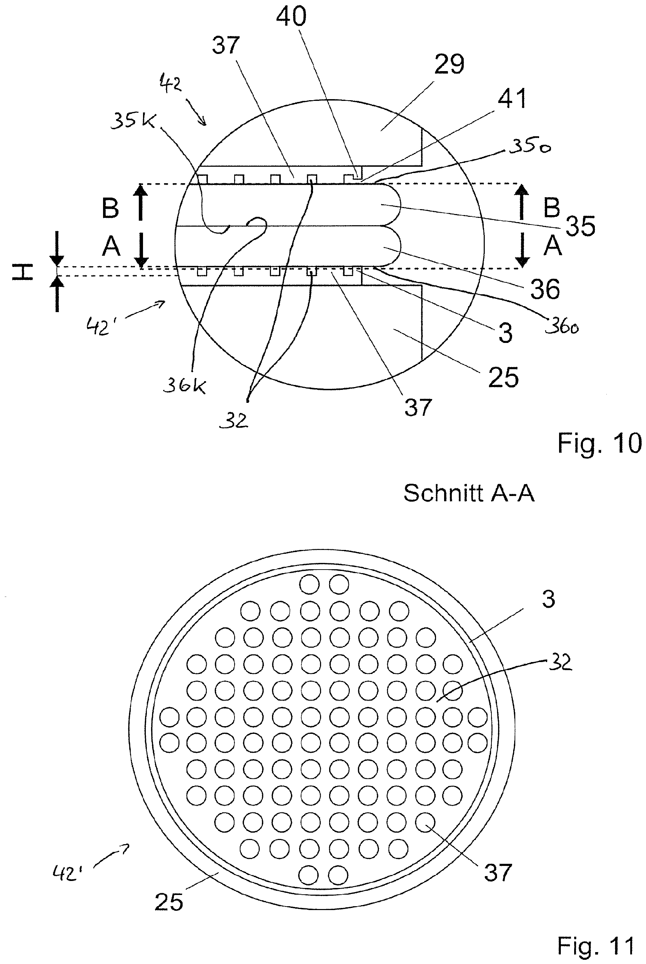

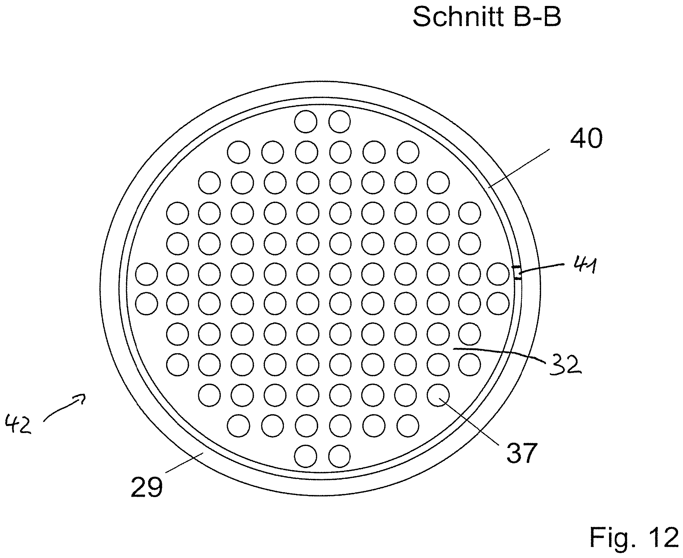

Die Figur 12 zeigt eine, nicht maßstabsgetreue, schematische Oberansicht der auf der ersten Druckplatte 29 fixierten Noppendruckplatte 42 mit mehreren Noppen 37 mit einer Noppenhöhe H. Die Dichte der Noppen 37 ist in den Figuren 11 und 12 sehr gering gehalten, um die Anschaulichkeit zu erhöhen.

Vorzugsweise weisen die Noppendruckplatten 42, 42' jeweils mindestens 50, insbesondere regelmäßig und/oder gleich verteilte, Noppen 37, noch bevorzugter jeweils mindestens 100, noch bevorzugter jeweils mindestens 200, noch bevorzugter jeweils mindestens 400, auf.

Figur 11 zeigt eine schematische Schnittansicht gemäß Schnittlinie A-A aus Figur 10 mit der zweiten Druckplatte 25 mit der Noppendruckplatte 42'. Man erkennt in dieser Darstellung, dass nicht die gesamte Oberfläche der Substrate 35, 36 auf den Noppen 37 aufliegt, wodurch die Wahrscheinlichkeit der Kontamination der Substrate 35, 36 verringert wird.

Die Abstände A und B sind auf Null reduziert, so dass ein Kontakt zwischen Heizflächen 15, 19 der Noppendruckplatten 42, 42' und den Oberflächen 35o, 36o besteht.

### Bezugszeichenliste

- 1: Ausrichtungseinrichtung
- 2: Ventile
- 3: Dichtungsring
- 4, 4': Vakuumtransferkammer
- 5: Vakuumtransferstrecke
- 6: Bondeinrichtung
- 6o: Kammeröffnung
- 6s: Schlitz
- 7: Tragkonstruktion
- 8: Positionsaktuator
- 9: Kraftaktuator
- 10: Bondkammer, insbesondere Vakuumkammer
- 11: Fixierungen
- 14: Substratstapel
- 15, 15': Erste Heizfläche
- 16: Pumpe
- 17: Strahlungswärme
- 18: Aufnahmeeinrichtung, insbesondere Substratauflage
- 19, 19': Zweite Heizfläche
- 20: Dichtungen
- 21: Beladestifte
- 21p: Stellplatte
- 22: Stellantrieb, insbesondere Beladestiftaktuator
- 23: Tragkonstruktion
- 24: Schleusenantrieb
- 25: zweite Druckplatte
- 26: Zweite, insbesondere untere, Heizeinrichtung
- 27: Ventil
- 28: Schleusendichtungen
- 29: Erste Druckplatte
- 30: Erste, insbesondere obere, Heizeinrichtung
- 31: Dichtungen
- 32: Strömungskanäle
- 34: Roboter, insbesondere Prozessroboter
- 35: Erstes, insbesondere oberes, Substrat
- 35k: Erste Kontaktfläche
- 35o: Erste Oberfläche
- 36: Zweites, insbesondere unteres, Substrat
- 36k: Zweite Kontaktfläche
- 36o: Zweite Oberfläche
- 37: Noppen
- 38, 38': Anlage, insbesondere Vakuumcluster, vorzugsweise Hochvakuumcluster
- 39: Schleusen
- 40: Steg
- 41: Durchlass
- 42, 42': Noppendruckplatte
- A: Abstand
- B: Abstand
- E: Auflageebene
- H: Noppenhöhe

## Patentansprüche

1. Verfahren zum Bonden einer ersten Kontaktfläche (35k) eines ersten Substrats (35) mit einer zweiten Kontaktfläche (36k) eines zweiten Substrats (36) mit folgendem Ablauf:
- Anordnung eines aus dem ersten Substrat (35) und dem zweiten Substrat (36) gebildeten, an den Kontaktflächen (35k, 36k) ausgerichteten Substratstapels (14) zwischen einer ersten Heizfläche (15) einer ersten Heizeinrichtung (30) und einer zweiten Heizfläche (19) einer zweiten Heizeinrichtung (26), wobei
a) die erste Heizfläche (15) einer von der ersten Kontaktfläche (35k) abgewandten ersten Oberfläche (35o) des ersten Substrats (35) zugewandt angeordnet wird,
b) die zweite Heizfläche (19) einer von der zweiten Kontaktfläche (36k) abgewandten zweiten Oberfläche (36o) des zweiten Substrats (36) zugewandt angeordnet wird,
c) zwischen der ersten Oberfläche (35o) und der ersten Heizfläche (15) ein Abstand A > 0µm vorliegt und
d) zwischen zweiten Oberfläche (36o) und der zweiten Heizfläche (19) ein Abstand B > 0µm vorliegt,
- Heizen der Heizflächen (15, 19), wobei die Substrate (35, 36) von den Heizflächen (15, 19) beabstandet sind und die Substrate (35, 36) durch Infrarotstrahlung von den Heizflächen (15, 19) geheizt werden, und während des Heizens Annähern des Substratstapels (14) an die Heizflächen (15, 19) durch Verringerung der Abstände A und B auf 0µm, wobei der Substratstapel (14) symmetrisch bezüglich der Ebene der Kontaktfläche der Substrate des Substratstapels erwärmt wird,
- Ausbildung eines Bonds zwischen der ersten Kontaktfläche (35k) und zweiten Kontaktfläche (36k) durch Druckbeaufschlagung des Substratstapels (14) an den Oberflächen (35o, 36o).

2. Verfahren nach Anspruch 1, bei dem das Annähern an die Heizflächen (15, 19) symmetrisch zum Substratstapel (14), insbesondere symmetrisch zu den Oberflächen (35o, 36o) und/oder symmetrisch zu den Kontaktflächen (35k, 36k), und/oder mit gleicher Temperatur der Heizflächen (15, 19) erfolgt.

3. Verfahren nach einem der vorhergehenden Ansprüche, bei dem die Heizflächen (15, 19) jeweils größer sind als die den Heizflächen (15, 19) jeweils zugewandten Oberflächen (35o, 36o) des Substratstapels (14).

4. Verfahren nach einem der vorhergehenden Ansprüche, bei dem die erste Heizfläche (15) oder die zweite Heizfläche (19) beim Annähern nicht bewegt wird.

5. Verfahren nach einem der vorhergehenden Ansprüche, bei dem die Heizeinrichtungen (30, 26) beim Heizen und das Annähern derart gesteuert werden, dass zumindest während der überwiegenden Dauer des Annäherns die Differenz der mittleren Temperatur des ersten Substrats (35) und der mittleren Temperatur des zweiten Substrats (36) kleiner 5°C, insbesondere kleiner 1°C, bevorzugt kleiner 0,5°C, noch bevorzugter kleiner 0,1°C, beträgt.

6. Verfahren nach einem der vorhergehenden Ansprüche, bei dem der Substratstapel (14) vor der Anordnung zwischen den Heizflächen (15, 19) vorgeheizt wird, insbesondere außerhalb einer die Heizeinrichtungen (30, 26), insbesondere vakuumierbar, umschließenden Bondkammer (10) einer Bondeinrichtung (6).

7. Verfahren nach einem der vorhergehenden Ansprüche, bei dem die Anordnung des Substratstapels (14) zwischen den Heizflächen (15, 19) und/oder das Heizen und/der das Annähern und/oder die Ausbildung des permanenten Bonds im Vakuum erfolgt/erfolgen.

8. Verfahren nach einem der vorhergehenden Ansprüche, bei dem die Heizeinrichtungen (30, 26) beim Heizen und das Annähern derart gesteuert werden, dass die an de ersten Oberfläche (35o) auftreffende Strahlungsenergie (17) der ersten Heizfläche (15) während des Annäherns gleich ist wie die an der zweiten Oberfläche (36o) auftreffende Strahlungsenergie (17) der zweiten Heizfläche (19).

9. Vorrichtung zum Bonden einer ersten Kontaktfläche (35k) eines ersten Substrats (35) mit einer zweiten Kontaktfläche (36k) eines zweiten Substrats (36) mit:
- Aufnahme eines aus dem ersten Substrat (35) und dem zweiten Substrat (36) gebildeten, an den Kontaktflächen (35k, 36k) ausgerichteten Substratstapels (14) mittels einer zwischen einer ersten Heizfläche (15) einer ersten Heizeinrichtung (30) und einer zweiten Heizfläche (19) einer zweiten Heizeinrichtung (26) angeordneten Aufnahmeeinrichtung (18), die derart anordenbar und steuerbar ist/sind, dass
a) die erste Heizfläche (15) einer von der ersten Kontaktfläche (35k) abgewandten ersten Oberfläche (35o) des ersten Substrats (35) zugewandt angeordnet ist,
b) die zweite Heizfläche (19) einer von der zweiten Kontaktfläche (36k) abgewandten zweiten Oberfläche (36o) des zweiten Substrats (36) zugewandt angeordnet ist,
c) zwischen der ersten Oberfläche (35o) und der ersten Heizfläche (15) ein Abstand A > 0µm vorliegt und
d) zwischen zweiten Oberfläche (36o) und der zweiten Heizfläche (19) ein Abstand B > 0µm vorliegt,
- Heizeinrichtungen (26, 30) zum Heizen der Heizflächen (15, 19), wobei die Substrate (35, 36) von den Heizflächen (15, 19) beabstandet sind und die Substrate (35, 36) durch Infrarotstrahlung von den Heizflächen (15, 19) heizbar sind, und Antriebsmitteln zum Annähern des Substratstapels (14) an die Heizflächen (15, 19) durch Verringerung der Abstände A und B auf 0µm, wobei der Substratstapel (14) symmetrisch bezüglich der Ebene der Kontaktfläche der Substrate des Substratstapels erwärmbar ist,
- Bondmitteln zur Ausbildung eines Bonds zwischen der ersten Kontaktfläche (35k) und zweiten Kontaktfläche (36k) durch Druckbeaufschlagung des Substratstapels (14) an den Oberflächen (35o, 36o).

10. Vorrichtung nach Anspruch 9, wobei die erste Heizfläche (15) und/oder die zweite Heizfläche (19) durch Noppen (37) mit zwischen den Noppen (37) verlaufenden Strömungskanälen (32) zur Beaufschlagung, insbesondere Durchströmung, mit einem Gas gebildet sind.

11. Vorrichtung nach Anspruch 10, wobei die Strömungskanäle (32) von einem, insbesondere ringförmigen, Steg (40) zur Abdichtung der Strömungskanäle (32) zum ersten und/oder zweiten Substrat (35, 36) umgeben, insbesondere umschlossen, sind.

12. Vorrichtung nach Anspruch 11, wobei der Steg (40) eine Öffnung (41) zum kontrollierten Ausleiten des Gases aufweist.

## Claims

1. A method for bonding a first contact surface (35k) of a first substrate (35) with a second contact surface (36k) of a second (36) with the following sequence:
- arrangement of a substrate stack (14), formed from the first substrate (35) and the second substrate (36) and aligned at the contact surfaces (35k, 36k), between a first heating surface (15) of a first heating system (30) and a second heating surface (19) of a second heating system (26), wherein
a) the first heating surface (15) is arranged facing a first surface (35o) of the first substrate (35), said first surface facing away from the first contact surface (35k),
b) the second heating surface (19) is arranged facing a second surface (36o) of the second substrate (36), said the second surface facing away from the second contact surface (36k),
c) between the first surface (35o) and the first heating surface (15), there is a separation distance A > 0 µm, and
d) between the second surface (36o) and the second heating surface (19), there is a separation distance B > 0 µm,
- heating the heating surfaces (15, 19), wherein the substrates (35, 36) are spaced apart from the heating surfaces (15, 19) and the substrates (35, 36) are heated by infrared radiation from the heating surfaces (15, 19), and during the heating the substrate stack (14) converges with the heating surfaces (15, 19) by reducing the separation distances A and B to 0 µm, wherein the substrate stack (14) is heated symmetrically relative to the plane of the contact surface of the substrates of the substrate stack,
- forming bond between the first contact surface (35k) and the second contact surface (36k) by pressurisation of the substrate stack (14) on the surfaces (35o, 36o).

2. The method according to claim 1, wherein the converging on the heating surfaces (15, 19) takes place symmetrically with respect to the substrate stack (14), in particular symmetrically to the surfaces (35o, 36o) and/or symmetrically to the contact surfaces (35k, 36k) and/or at the same temperature of the heating surfaces (15, 19).

3. The method according to any one of the preceding claims, wherein the heating surfaces (15, 19) are in each case larger than the surfaces (35o, 36o) of the substrate stack (14) that in each case face the heating surfaces (15, 19).

4. The method according to any one of the preceding claims, wherein the first heating surface (15) or the second heating surface (19) is not moved during converging.

5. The method according to any one of the preceding claims, wherein the heating systems (30, 26) are controlled during heating and converging in such a way that at least during the vast majority of the converging period, the difference between the mean temperature of the first substrate (35) and the mean temperature of the second substrate (36) is less than 5°C, in particular less than 1°C, preferably less than 0.5°C, and still more preferably less than 0.1°C.

6. The method according to any one of the preceding claims, wherein the substrate stack (14) is preheated before the arrangement between the heating surfaces (15, 19), in particular outside a bonding chamber (10) of a bonding system (6) surrounding the heating systems (30, 26), in particular a vacuumable manner.

7. The method according to any one of the preceding claims, wherein the arrangement of the substrate stack (14) between the heating surfaces (15, 19) and/or the heating and/or the converging and/or the formation of the permanent bond takes/take place in a vacuum.

8. The method according to any one of the preceding claims, wherein the heating systems (30, 26) are controlled during the heating and the converging in such a way that the radiation energy (17) of the first heating surface (15) striking the first surface (35o) during the converging is the same as the radiation energy (17) of the second heating surface (19) striking the second surface (36o).

9. A device for bonding a first contact surface (35k) of a first substrate (35) with a second contact surface (36k) of a second substrate (36) with:
- receiving a substrate stack (14), formed from the first substrate (35) and the second substrate (36) and aligned on the contact surfaces (35k, 36k), by means of a receiving system (18) arranged between a first heating surface (15) of a first heating system (30) and a second heating surface (19) of a second heating system (26), said receiving system being able to be arranged and controlled in such a way that
a) the first heating surface (15) is arranged facing a first surface (35o) of the first substrate (35), said first surface facing away from the first contact surface (35k),
b) the second heating surface (19) is arranged facing a second surface (36o) of the second substrate (36), said second surface facing away from the second contact surface (36k),
c) between the first surface (35o) and the first heating surface (15), there is a separation distance A > 0 µm, and
d) between the second surface (36o) and the second heating surface (19), there is a separation distance B > 0 µm,
- heating systems (26, 30) for heating the heating surfaces (15, 19), wherein the substrates (35, 36) are spaced apart from the heating surfaces (15, 19) and the substrates (35, 36) can be heated by infrared radiation from the heating surfaces (15, 19), and drive means for converging the substrate stack (14) on the heating surfaces (15, 19) by reducing the separation distances A and B to 0 µm, wherein the substrate stack (14) can be heated symmetrically relative to the plane of the contact surface of the substrates of the substrate stack,
- bonding means for forming a bond between the first contact surface (35k) and the second contact surface (36k) by pressurisation of the substrate stack (14) on the surfaces (35o, 36o).

10. The device according to claim 9, wherein the first heating surface (15) and/or the second heating surface (19) are formed by studs (37) with flow channels (32) running between the studs (37) for pressurization, in particular flushing, with a gas.

11. The device according to claim 10, wherein the flow channels (32) are surrounded, in particular enclosed, by an in particular circular arm (40) for sealing the flow channels (32) with respect to the first and/or second substrate (35, 36).

12. The device according to claim 11, wherein the arm (40) has an opening (41) for the controlled discharge of the gas.

## Revendications

1. Procédé de liaison d'une première face de contact (35k) d'un premier substrat (35) avec une deuxième face de contact (36k) d'un deuxième substrat (36) comprenant le déroulement suivant :
- agencement d'une pile de substrats (14) formée du premier substrat (35) et du deuxième substrat (36) alignée contre les faces de contact (35k, 36k), entre une première face de chauffage (15) d'un premier dispositif de chauffage (30) et une deuxième face de chauffage (19) d'un deuxième dispositif de chauffage (26), dans lequel
a) la première face de chauffage (15) est disposée tournée vers une première surface (35o) du premier substrat (35) détournée de la première face de contact (35k),
b) la deuxième face de chauffage (19) est tournée vers une deuxième surface (36o) du second substrat (36) détournée de la seconde face de contact (36k),
c) entre la première surface (35o) et la première face de chauffage (15), un écart A > 0 µm est présent, et
d) entre la deuxième surface (36o) et la deuxième face de chauffage (19), un écart B > 0 µm est présent,
- chauffage des faces de chauffage (15, 19), dans lequel les substrats (35, 36) sont distants des faces de chauffage (15, 19) et les substrats (35, 36) sont chauffés par les faces de chauffage (15, 19) par rayonnement infrarouge, et pendant le chauffage, rapprochement de la pile de substrats (14) contre les faces de chauffage (15, 19) par réduction des écarts A et B à 0 µm, dans lequel la pile de substrats (14) est chauffée de manière symétrique par rapport au plan de la face de contact des substrats de la pile de substrats,
- formation d'une liaison entre la première face de contact (35k) et la deuxième face de contact (36k) par sollicitation en pression de la pile de substrats (14) sur les surfaces (35o, 36o).

2. Procédé selon la revendication 1, dans lequel le rapprochement contre les faces de chauffage (15, 19) s'effectue de manière symétrique à la pile de substrats (14), en particulier de manière symétrique aux surfaces (35o, 36o) et/ou de manière symétrique aux faces de contact (35k, 36k) et/ou à température égale des faces de chauffage (15, 19).

3. Procédé selon l'une des revendications précédentes, dans lequel les faces de chauffage (15, 19) sont respectivement plus grandes que les surfaces (35o, 36o) de la pile de substrats (14) tournées respectivement vers les faces de chauffage (15, 19).

4. Procédé selon l'une des revendications précédentes, dans lequel la première face de chauffage (15) ou la deuxième face de chauffage (19) n'est pas déplacée lors du rapprochement.

5. Procédé selon l'une des revendications précédentes, dans lequel les dispositifs de chauffage (30, 26) sont ainsi pilotés lors du chauffage et du rapprochement qu'au moins pendant la majeure partie de la durée du rapprochement, la différence de la température moyenne du premier substrat (35) et de la température moyenne du deuxième substrat (36) est inférieure à 5°C, en particulier inférieure à 1°C, de préférence inférieure à 0,5°C, plus encore de préférence inférieure à 0,1°C.

6. Procédé selon l'une des revendications précédentes, dans lequel la pile de substrats (14) est pré-chauffée avant l'agencement entre les faces de chauffage (15, 19), en particulier en-dehors d'une chambre de liaison (10) d'un dispositif de liaison (6) pouvant en particulier être mise sous vide, entourant les dispositifs de chauffage (30, 26).

7. Procédé selon l'une des revendications précédentes, dans lequel l'agencement de la pile de substrats (14) entre les faces de chauffage (15, 19) et/ou le chauffage et/ou le rapprochement et/ou la formation de la liaison permanente s'effectue(nt) sous vide.

8. Procédé selon l'une des revendications précédentes, dans lequel dispositifs de chauffage (30, 26) sont ainsi pilotés lors du chauffage et du rapprochement, que l'énergie de rayonnement (17) de la première face de chauffage (15) arrivant sur la première surface (35o), est égale pendant le rapprochement à l'énergie de rayonnement (17) de la deuxième face de chauffage (19) arrivant sur la deuxième surface (36o).

9. Dispositif de liaison d'une première face de contact (35k) d'un premier substrat (35) avec une deuxième face de contact (36k) d'un deuxième substrat (36) comprenant :
- la réception d'une pile de substrats (14) formée du premier substrat (35) et du deuxième substrat (36) alignée contre les faces de contact (35k, 36k), au moyen d'un dispositif de réception (18) agencé entre une première face de chauffage (15) d'un premier dispositif de chauffage (30) et une deuxième face de chauffage (19) d'un deuxième dispositif de chauffage (26), le dispositif de réception pouvant être piloté et agencé de telle sorte que
a) la première face de chauffage (15) est disposée tournée vers une première surface (35o) du premier substrat (35) détournée de la première face de contact (35k),
b) la deuxième face de chauffage (19) est tournée vers une deuxième surface (36o) du second substrat (36) détournée de la seconde face de contact (36k),
c) entre la première surface (35o) et la première face de chauffage (15), un écart A > 0 µm est présent, et
d) entre la deuxième surface (36o) et la deuxième face de chauffage (19), un écart B > 0 µm est présent,
- des dispositifs de chauffage (26, 30) pour le chauffage des faces de chauffage (15, 19), dans lequel les substrats (35, 36) sont distants des faces de chauffage (15, 19) et les substrats (35, 36) peuvent être chauffés par les faces de chauffage (15, 19) par rayonnement infrarouge, et des moyens d'entraînement pour rapprocher la pile de substrats (14) contre les faces de chauffage (15, 19) par réduction des écarts A et B à 0 µm, dans lequel la pile de substrats (14) peut être chauffée de manière symétrique par rapport au plan de la face de contact des substrats de la pile de substrats,
- des moyens de liaison pour former une liaison entre la première face de contact (35k) et la deuxième face de contact (36k) par sollicitation en pression de la pile de substrats (14) sur les surfaces (35o, 36o).

10. Dispositif selon la revendication 9, dans lequel la première face de chauffage (15) et/ou la deuxième face de chauffage (19) sont formées par des picots (37) avec des canaux d'écoulement (32) passant entre les picots (37), pour fournir, en particulier faire passer un gaz.

11. Dispositif selon la revendication 10, dans lequel les canaux d'écoulement (32) sont entourés, en particulier enceints par une traverse (40) en particulier annulaire, en étanchéifier les canaux d'écoulement (32) par rapport au premier et/au deuxième substrat (35, 36).

12. Dispositif selon la revendication 11, dans lequel la traverse (40) présente une ouverture (41) pour l'évacuation contrôlée du gaz.
